(19) Europäisches Patentamt

European Patent Office

Office européen des brevets

(11) **EP 1 217 751 A2**

(12) **EUROPEAN PATENT APPLICATION**

(43) Date of publication:
26.06.2002 Bulletin 2002/26

(51) Int Cl.7: **H03M 13/15**

(21) Application number: 01128379.3

(22) Date of filing: 03.12.2001

(84) Designated Contracting States:
**AT BE CH CY DE DK ES FI FR GB GR IE IT LI LU MC NL PT SE TR**
Designated Extension States:
**AL LT LV MK RO SI**

(30) Priority: **15.12.2000 US 738202**

(71) Applicant: **Alcatel USA Sourcing, L.P.**
**Plano, Texas 75075-5813 (US)**

(72) Inventor: **Lei, Mike**
**Dallas, Texas (US)**

(74) Representative:
**Dreiss, Fuhlendorf, Steimle & Becker**
**Patentanwälte,**
**Postfach 10 37 62**
**70032 Stuttgart (DE)**

(54) **Optimized parallel in parallel out GF(2M) multiplier for FEC decoder**

(57) The present invention achieves technical advantages as a multiplier circuit. The multiplier circuit multiplies GF ($2^{13}$) vectors to implement sigma calculations and a Chien search. This multiplier takes two inputs to be multiplied and outputs the resulting multiplication in GF ($2^{13}$) vectors in only one clock cycle. The multiplier circuit is customized to operate with OC-48 and OC-192 data, and is operable to meet the SONET Standard T1X1.5/99-218R3 and the SDH Standard ITU-T.G.707/Y.1322.

*FIG. 1A*

**Description**

**CROSS REFERENCE TO RELATED APPLICATIONS**

Cross reference is made to the following co-pending commonly assigned pending applications the teachings included herein by reference: U.S. Serial Number 09/738,196 entitled "IN-BAND FEC ENCODER FOR SONET"; U.S. Serial Number 09/738,198, entitled "IN-BAND FEC DECODER FOR SONET"; U.S. Serial Number 09/738,197, entitled "IN-BAND FEC SYNDROME COMPUTATION FOR SONET"; U.S. Serial Number 09/738,220, entitled "IN-BAND ERROR PERFORMANCE MONITORING MODULE FOR SONET"; U.S. Serial Number 09/738,988, entitled "OPTIMIZED PARALLEL IN PARALLEL OUT GF ($2^M$) SQUARER FOR FEC DECODER".

**FIELD OF THE INVENTION**

The present invention is related to optical communication systems, and more particularly to forward error correction (FEC) functions in those networks.

**BACKGROUND OF THE INVENTION**

As SONET and SDH data rates get to 2.5Gbps and above, they need to be transported over long fiber optics cable. This makes it increasingly important to not only detect errors in the transmission, but also to correct the errors to prevent frequent error conditions that would require protection switching.

In 1998, an effort was launched by the ANSI T1X1.5 technical subcommittee, including the applicant of the present invention, to develop a Standard for an in-band forward error correction (FEC) algorithm for use in SONET transmission equipment. (This Standard will be referred to as the "Standard" throughout the rest of the application). The draft describes a Standard for in-band FEC where the FEC check bits and status/control bits are carried within the existing SONET overhead.

The scope of the SONET Standard is for OC-48 and OC-192. This Standard provides up to 3 error corrections per row per bit-slice for a STS-48 block. For a STS-48 frame, it provides 3 x 9 rows x 8 bits=216 bit error corrections. Conforming circuitry should also be able to detect uncorrectable error conditions (i.e., when there is more than 3 errors per row per bit-slice). Conceptually, the FEC layer falls below the line layer and provides a "correction service" to the line layer. For more details, reference the Standard included in this application.

There is desired in-band FEC circuitry and methodology applicable for both SONET and SDH that meets the requirements of these proposed Standards and that gives optimal performance in terms of circuitry area and time to do the encoding and decoding. The circuitry and methodology should be operable in OC-48 and OC-192 data rates and disable OC-12 data, should also meet the latency requirements of the Standards, and may preferably be used for higher data rates.

**SUMMARY OF THE INVENTION**

The present invention achieves technical advantages as a multiplier circuit. The multiplier circuit multiplies GF ($2^{13}$) vectors to implement sigma calculations and a Chien search. This multiplier takes two inputs to be multiplied and outputs the resulting multiplication in GF ($2^{13}$) vectors in only one clock cycle. The multiplier circuit may be customized to operate with OC-48 and OC-192 data, and is operable to meet both the SONET Standard T1X1.5/99-218R3 and the SDH Standard ITU-T.G.707/Y.1322.

**BRIEF DESCRIPTION OF THE DRAWINGS**

Figure 1A is an overall block diagram of a 10 Gbit/s SONET ADM (Add/Drop MUX) depicting where FEC of the present invention resides;

Figure 1B depicts the FEC generation;

Figure 1 C depicts the FEC termination;

Figure 1D is an overall block diagram of a forward error correction (FEC) system for SONET according to the present invention;

Figure 2 is a top-level block diagram of the FEC encoder;

Figure 3 is a block diagram of the FEC bit-slice encoder;

Figure 4 is a block diagram of the FEC encoder;

Figure 5 is a top level block diagram of the FEC decoder;

Figure 6 is a block diagram of the bit-decoder;

Figure 7 is a block diagram of the FEC bit-slice decoder;

Figure 8 is a block diagram of the checkbit generator circuit;

Figure 9 is a signal timing diagram for the checkbit generator of Figure 8;

Figure 10A is a block diagram of the syndrome 1 calculation circuit;

Figure 10B is a block diagram of the syndrome 3 calculation circuit;

Figure 10C is a block diagram of the syndrome 5 calculation circuit;

Figure 11 is an illustration of the calculations for the syndrome G5 ($\alpha^5$) calculation circuit;

Figure 12 is the calculations for the syndrome G3 ($\alpha^3$);

Figure 13 illustrates the calculation for the G3 (x) syndrome calculations;

Figure 14 is a block diagram of the sigma3 computation circuit;

Figure 15 is another block diagram of the sigma2 computation circuit;

Figure 16A is a block diagram of the Chien search Top level error correction circuit;

Figure 16B is the block diagram of the CHIEN_SEARCH_1 block

Figure 16C is the block diagram of the CHIEN_SEARCH_CB block

Figure 18 depicts equations of the squaring circuit;

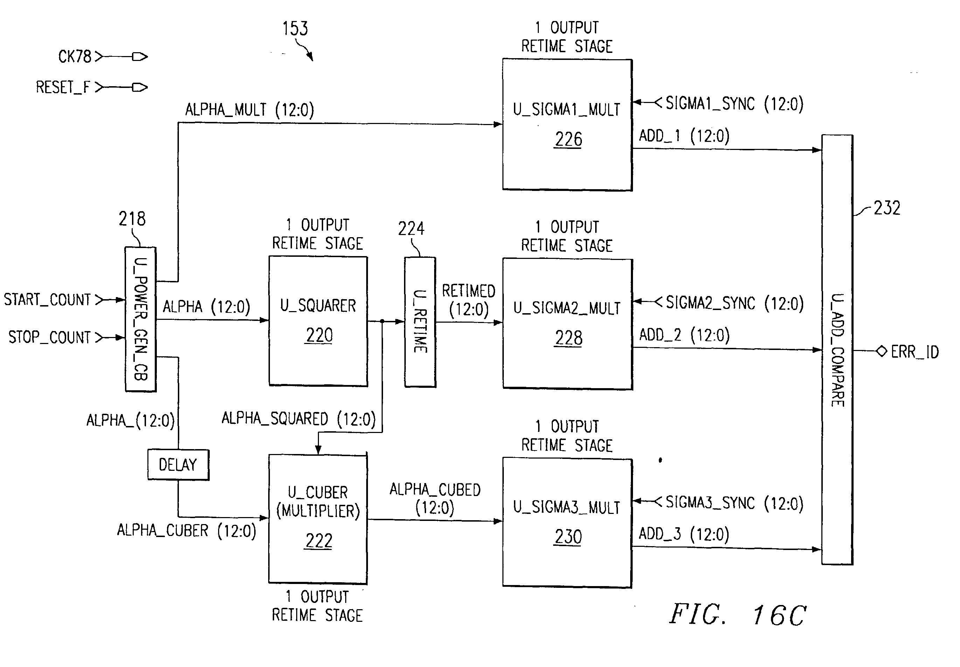

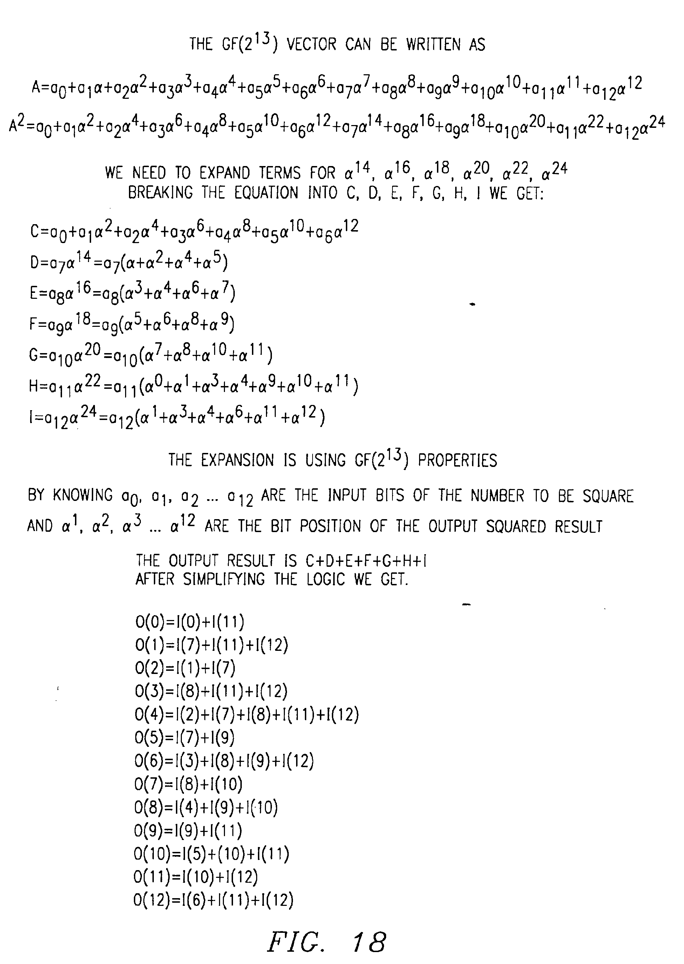

Figure 17 depicts the calculations for the squaring circuit of Figure 18;

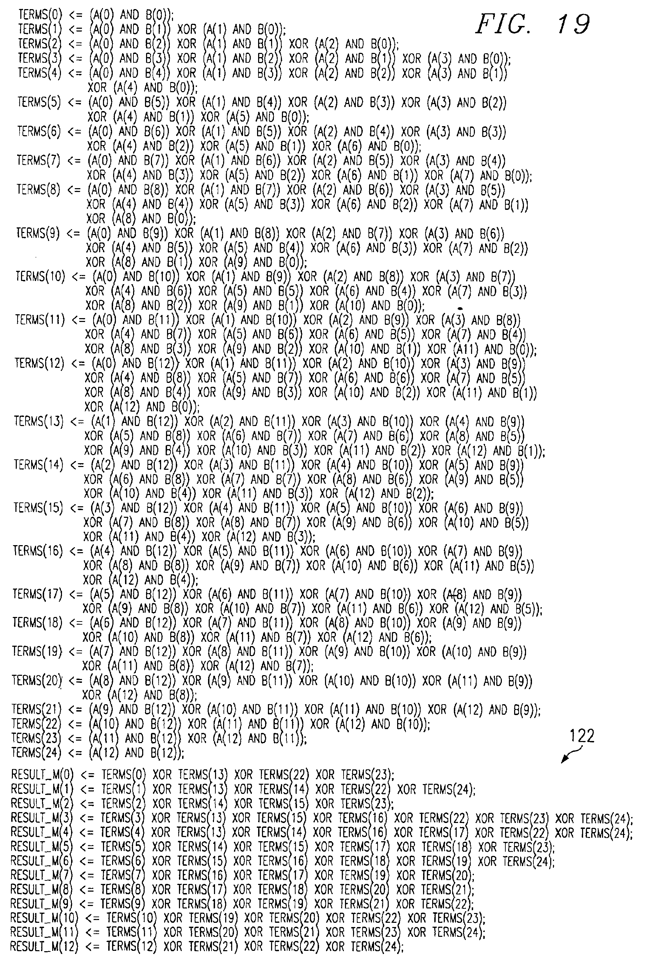

Figure 19 depicts the calculations for the multiplier circuit;

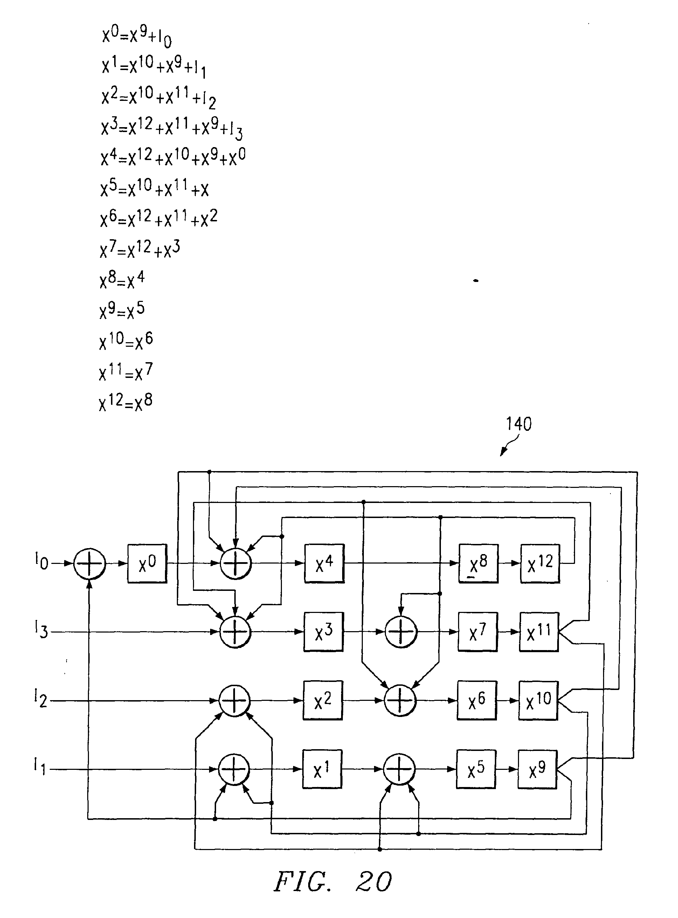

Figure 20 depicts a circuit implementing a 4-bit parallel LFSR for G1 (x);

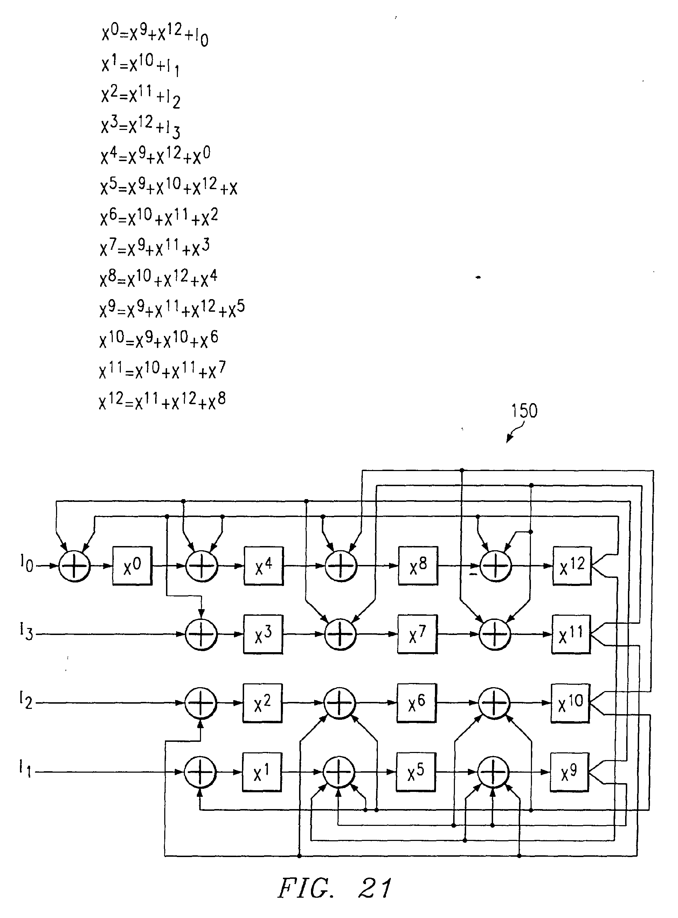

Figure 21 depicts a circuit implementing a 4-bit parallel LFSR for G3 (x);

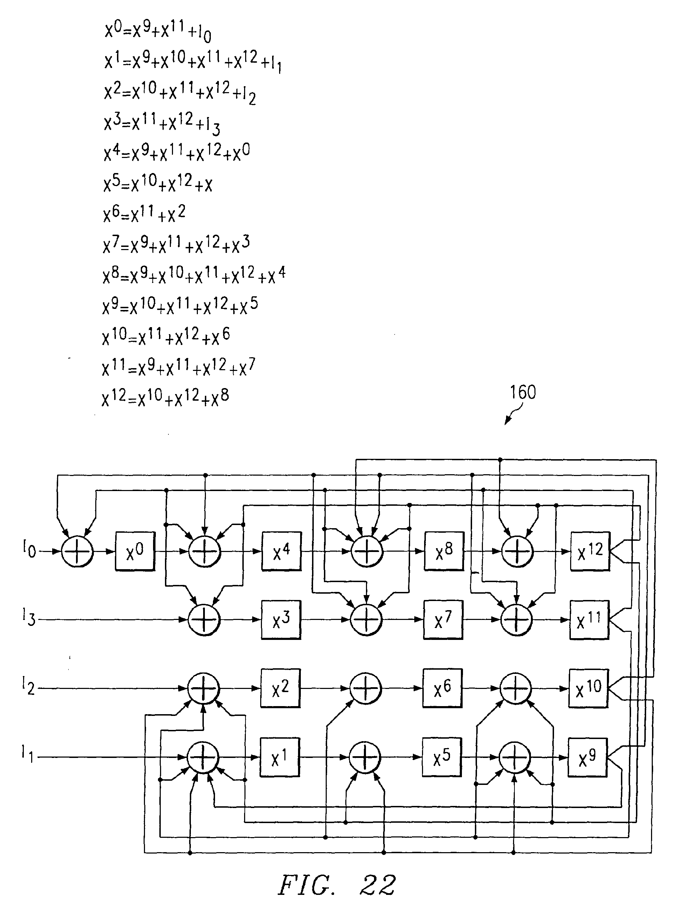

Figure 22 depicts a circuit implementing a 4-bit parallel LFSR for G5 (x);

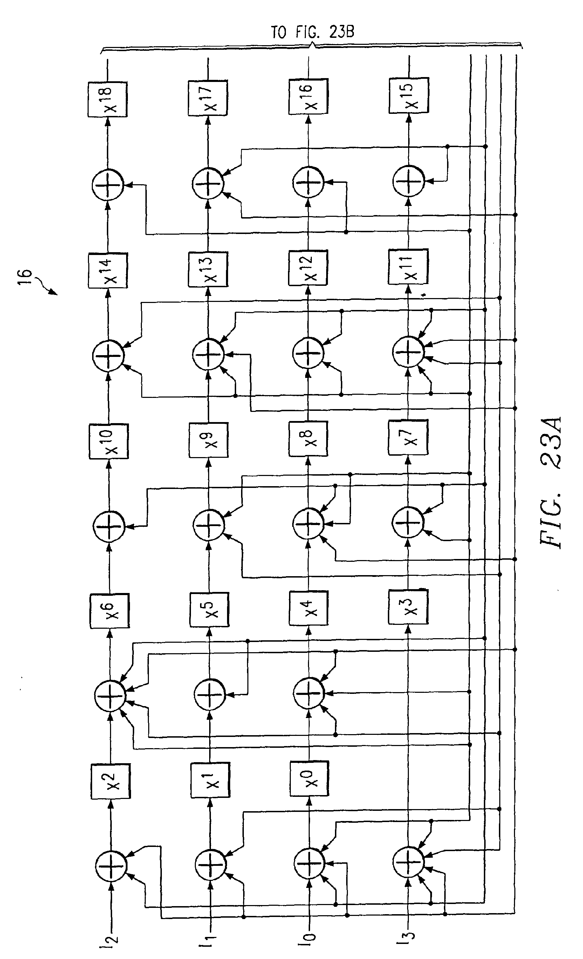

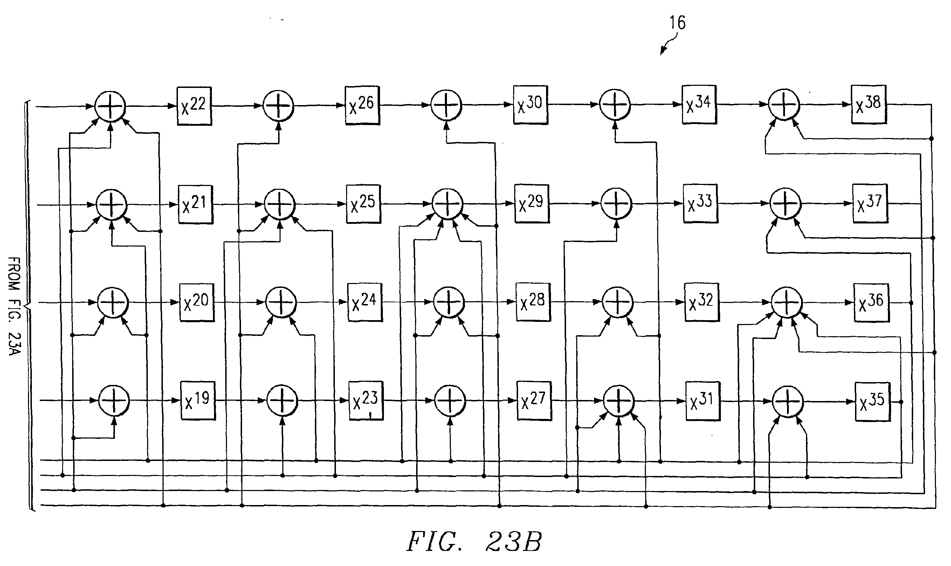

Figure 23 illustrates a circuit implementing a 4-bit parallel LFSR for G(x);

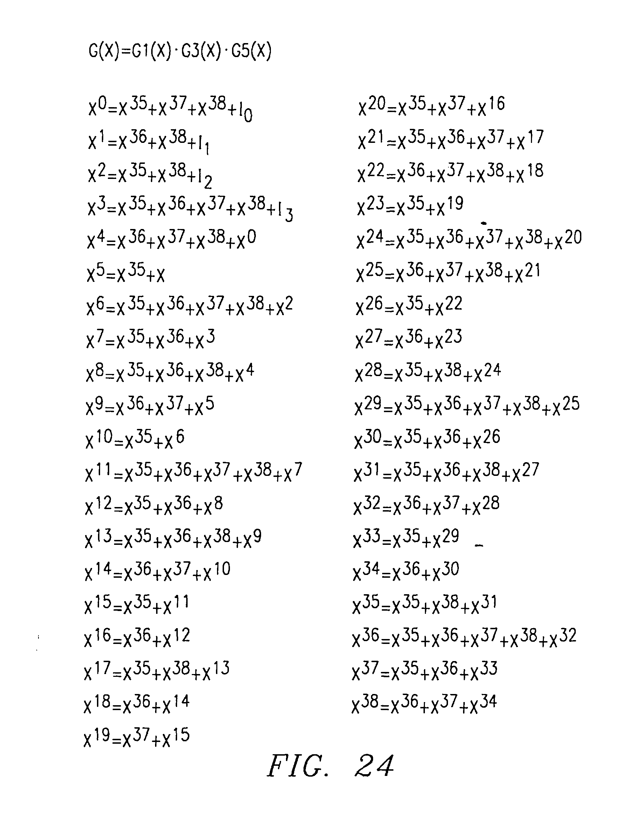

Figure 24 depicts the calculations for the circuit of Figure 23;

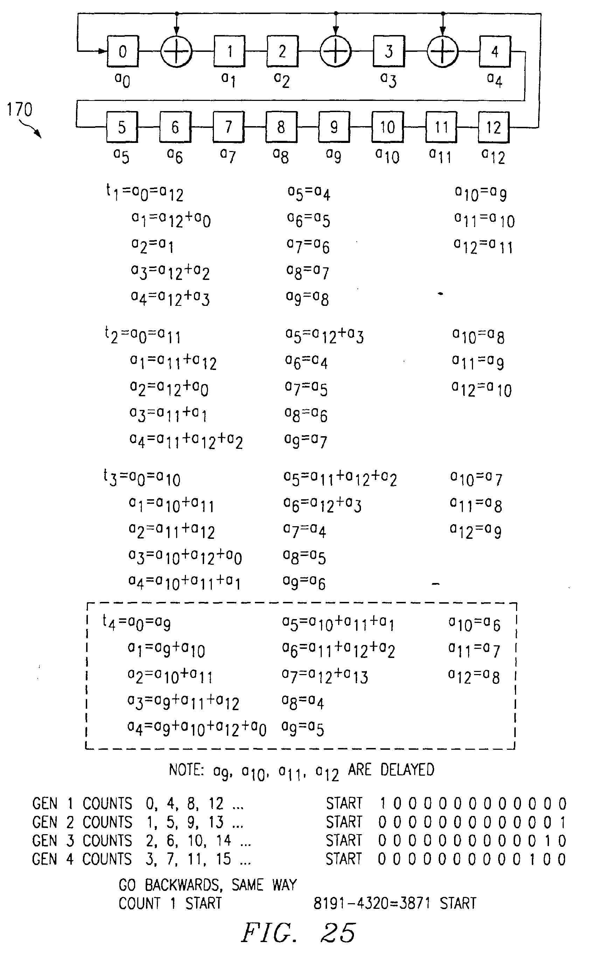

Figure 25 depicts calculation of 4 Galois field vector generator circuits that increments by 4; and

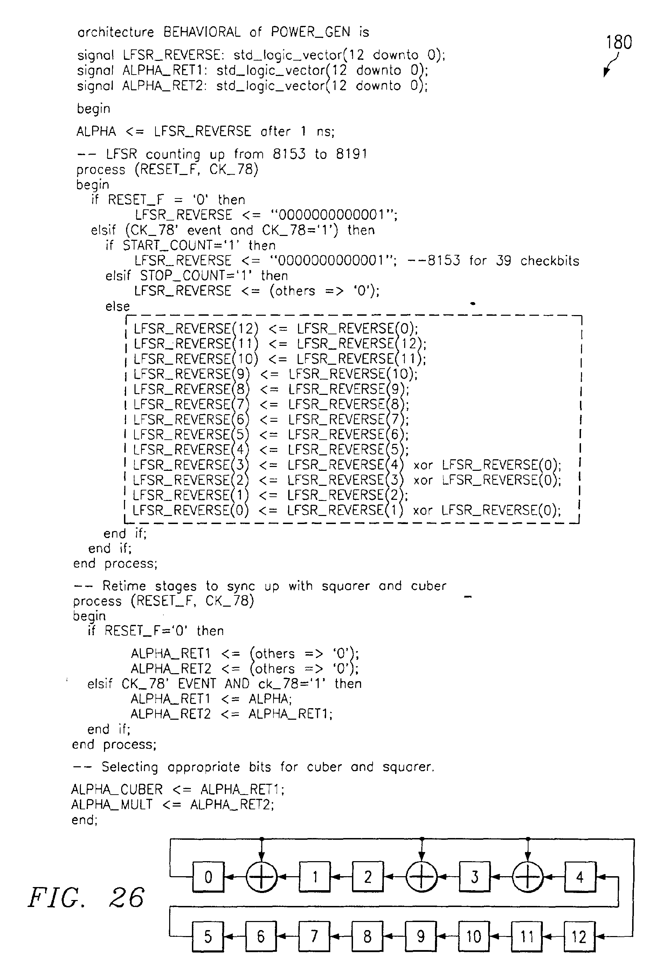

Figure 26 depicts a reverse GF ($2^{13}$) serial vector generator for FEC decoding.

## DETAILED DESCRIPTION OF THE PREFERRED EMBODIMENT

The following are details of the FEC encoder description and algorithm according to the present invention. As forward discussion, an overview of the SONET Standard is provided, with it being understood the SONET Standard is very similar to the SDH Standard, and the teachings of the present invention generally apply to both Standards where some variables differ but the equations and algorithms are substantially similar to one another.

### FEC Encoding description and Algorithm

The SONET Standard specifies the generator polynomial which is to be used for encoding of any cyclic codes as:

$$G(x) = G1(x)G3(x)G5(x),$$

where:

$$G1(x) = x^{13} + x^4 + x^3 + x + 1$$

$$G3(x) = x^{13} + x^{10} + x^9 + x^7 + x^5 + x^4 + 1$$

$$G5(x) = x^{13} + x^{11} + x^8 + x^7 + x^4 + x + 1$$

Codeword:          $C(x) = I(x) + R(x)$

Information bits:   $I(x) = a_{4358} x_{4358} + \ldots + a_{39}x^{39}$

Check bits:          $R(x) = I(x) \bmod G(x) = a_{38} x^{38} + \ldots + a_0$

The shortened BCH code is derived from a (8191, 8152) parent code.
The block size is 1 row (bit-slice) of STS-48 (4320 information bits plus 39 check bits per block).
Minimum code distance d=7 and number of correctable errors, t=3.

### Decoding FEC descriptions and algorithms.

FEC decoding of BCH code

The received code is: r(x)= C(x) + e(x), where:
    C(x) = codeword transmitted
    e(x)= error pattern

### Syndrome Calculations

Syndrome Values

$$S_k = r(\alpha^k) = C(\alpha^k) + e(\alpha^k) = e(\alpha^k) \qquad \text{Eq. 2.1}$$

since $C(\alpha^k) = 0$      $\alpha^k$ are roots of the BCH code.
k = 1, 3, 5, ..., 2t-1       (t is number of errors in received word, $t \leq 3$)
Thus, each element $S_k$ of the syndrome is simply the error-pattern polynomial e(x) evaluated at $x = \alpha_k$.
We call the i-th error locator $X_i$, from Eq. 2,1 we get:

$$S_1 = X_1 + X_2 + \ldots + X_t$$

$$S_2 = (X_1)^2 + (X_2)^2 + (X_t)^2 \qquad\qquad Eq.2.2$$

$$S_{2t} = (X_1)^{2t} + (X_2)^{2t} + (X_t)^{2t}$$

**Peterson Direct Solution Method**

Peterson showed that we can solve $S_k$ with the error-locator polynomial $\sigma(x)$ because $\sigma(x)$ evaluated at each error-locator value equals zero.

$$Eq\ 2.3 \qquad \sigma(X) = X_t + \sigma_1 X^{t-1} + \ldots \sigma_t$$

$$Eq\ 2.4 \qquad \sigma(X_i) = X_i^t + \sigma_1 X_i^{t-1} + \ldots \sigma_t \qquad i = 1,2,\ldots,t$$

Using Newton's identities for binary code, we get:

$$Eq.\ 2.5 \qquad S_1 + \sigma_1 = 0$$

$$S_3 + S_2\sigma_1 + S_1\sigma_2 + \sigma_3 = 0$$

$$S_5 + S_4\sigma_1 + S_3\sigma_2 + S_2\sigma_3 + S_1\sigma_4 + \sigma_5 = 0$$

and so on ...

**Chien Search**

To find the roots of the error-locator polynomial $\sigma(x)$, which are the error locators, and to correct the errors indicated, the Chien search is used. The Chien search steps sequentially through all possible error-locator values and corrects the corresponding bits as the locators are found.

By dividing Eq. 2.5 by $X^t$, the values of x that satisfy $\sigma(x) = 0$ satisfy the equation

$$\sigma_1 x^{-1} + \sigma_2 x^{-2} + \ldots \sigma_t x^{-t} = 1$$

Testing for $\alpha^{n-j}$ as an error locator is equivalent to finding whether or not $\sigma^j$ satisfies

$$Eq.\ 2.6 \qquad \Sigma \sigma_t \alpha^{ij} = \alpha^0 = 1, \qquad j = 0, 1, 2,\ldots, n\text{-}1$$

**FEC decoding in the present invention**

From Eq. 2.2

$$S_1 = X_1 + X_2 + X_3$$

$$S_3 = (X_1)^3 + (X_2)^3 + (X_3)^3$$

$$S_5 = (X_1)^5 + (X_2)^5 + (X_3)^5$$

For this invention:

$$S_1 = r(\alpha) \bmod G1(\alpha)$$

$$S_3 = r(\alpha^3) \bmod G3(\alpha^3)$$

$$S_5 = r(\alpha^5) \bmod G5(\alpha^5)$$

Solving for d1, d2, d3 from Eq. 2.5,

$$\sigma_1 = S_1$$

$$\sigma_2 = (S_1{}^2 S_3 + S_5)/(S_1{}^3 + S_3)$$

$$\sigma_3 = (S_1{}^3 + S_3) + S_1 \sigma_2$$

Only $S_1$, $S_3$, $S_5$ terms are used because for binary codes , $S_{2k} = S_k{}^2$, therefore:

$$(S_1)^2 = S_2, (S_1)^4 = S_4$$

using properties for Galois Field of $2^m$ elements $GF(2^m)$. For this application, m=13.

From Eq. 2.6, the Chien search for j , where j = 3833, 3834,...,8191

$$\text{Eq. 2.7} \qquad \sigma_1(\alpha^j) + \sigma_2(\alpha^j)^2 + \sigma_3(\alpha^j)^3 =? 1$$

If Eq. 2.7 = 1, then invert the bit at location 8192-j

**BEST MODE OF THE PREFERRED EMBODIMENT**

**FEC system top level design**

Referring now to Figure 1B, there is illustrated generally at 10 an in-band FEC system and methodology for SONET according to the preferred embodiment of the present invention. System 10 is seen to include an FEC encoder 12, and FEC decoder 11. The encoder 12 further includes a checkbit generator 14 and a linear feedback shift registers (LFSR) G(x) 16. The decoder 11 is seen to include syndrome generator 20, sigma calculation 22, and error correction circuit 24. Further provided is an uncorrectable error detection circuit 26. Syndrome generator 20 is seen to further include three LFSR's used in the FEC decoding, shown at 27, 28 and 30. A multiplier 32 and a squarer 34 are seen to be utilized by both the sigma calculation 22 and the error correction circuit 24. The error correction circuit 24 is seen to include four_increment by 4 LFSRs 36 and a serial LFSR shown at 38.

By way of illustration, but without limitation thereto, in one embodiment, the circuitry of the present invention 10 operates 4-bit parallel circuits at 78 Mhz. The encoder 12 circuit reduces the latency of the system 10 and fits into a typical STS-48 and STS-192 SONET receiver/transmitter system. In addition, serial circuitry that complements the parallel circuitry to do the encoding and decoding is utilized.

The present invention has many advantages over the prior art. For instance, the decoding circuits in FEC decoder 14 use discrete mathematical units for $GF(2^m)$ computations instead of a ROM table as in the prior art. The mathematical units, such as the squarer 34 and multiplier 32 compute in 1 clock cycle instead of many clock cycles. This speeds up the decoding and alleviates routing congestions. The blocks are partitioned to take advantage of the discrete mathematical circuitry and parallel circuitry to give low latency (or less delay).

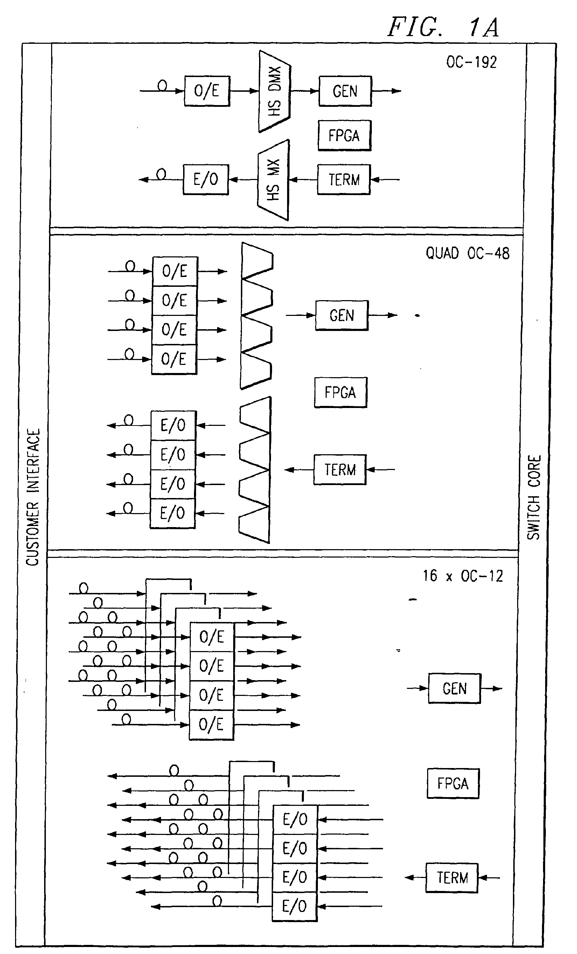

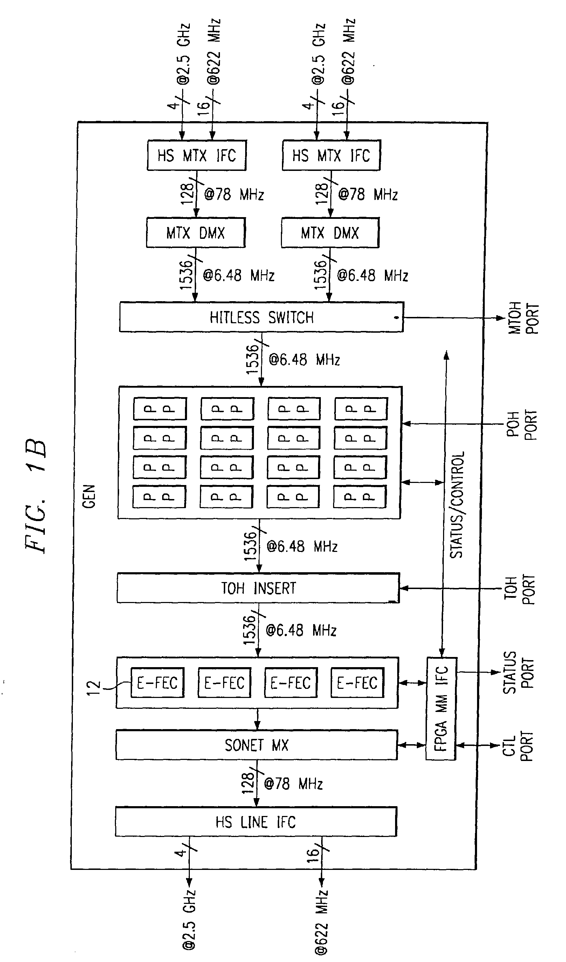

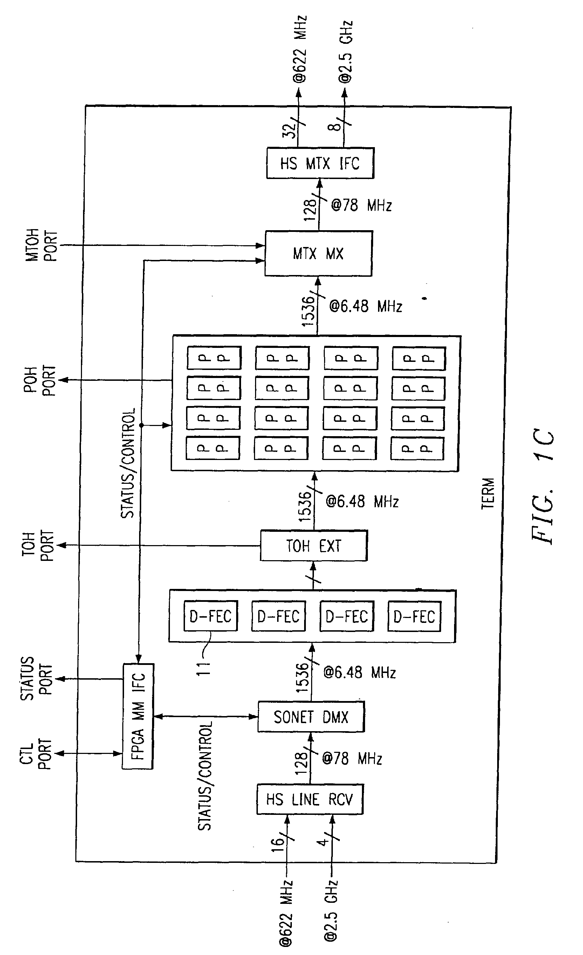

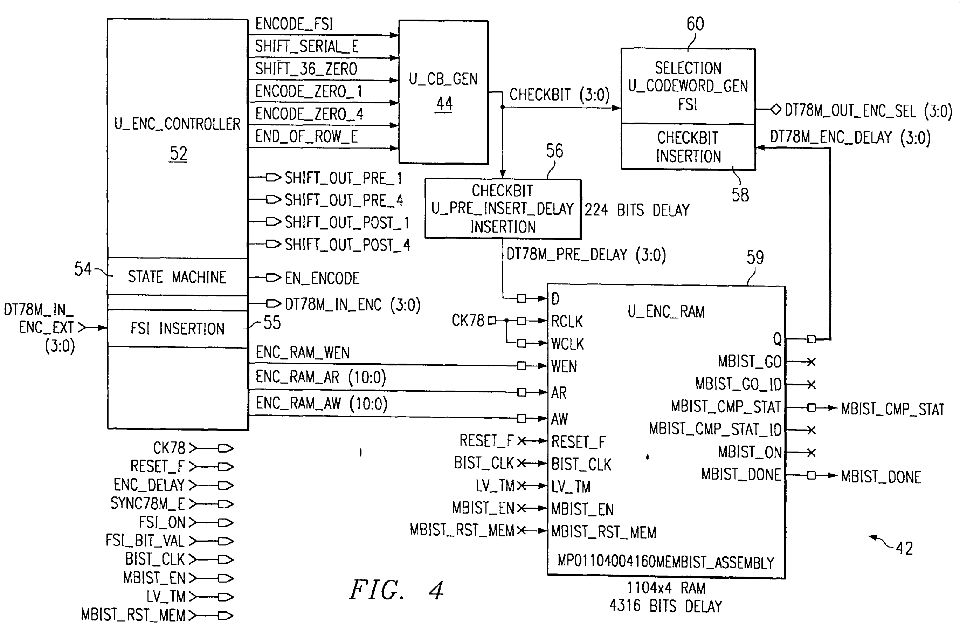

In an STS-48 application, such as shown in Figure 1A, 4 individual FEC encoding blocks and 4 FEC decoding blocks are used that process each bit of the byte. The blocks operate in parallel and have their own controller and frame counter. This provides up to 24 burst error correction per STS-48 row. For the decoder, another top level control block per STS-48 is provided.

In an STS-192 application, 16 individual FEC encoding blocks and 16 FEC decoding blocks are used that process each bit of the byte. The blocks operate in parallel and have their own controller and frame counter. For the decoder, another top level control block per STS-192 is provided.

For higher data rates, such as STS-768, the same methodology applies as STS-48 and STS-192.

**FEC Encoder top level design**

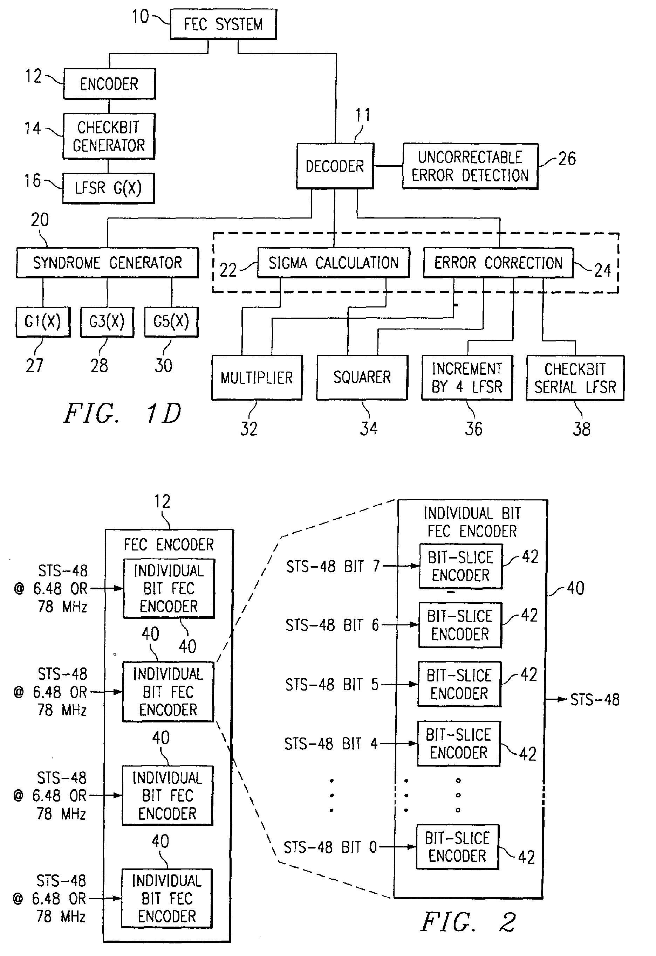

Referring to Figure 2, the FEC encoder 12 is made up of individual bit FEC encoders 40. The design of each bit encoder 40 is the same. The encoder 40 consists of 8 bit slice encoders as shown at 42.

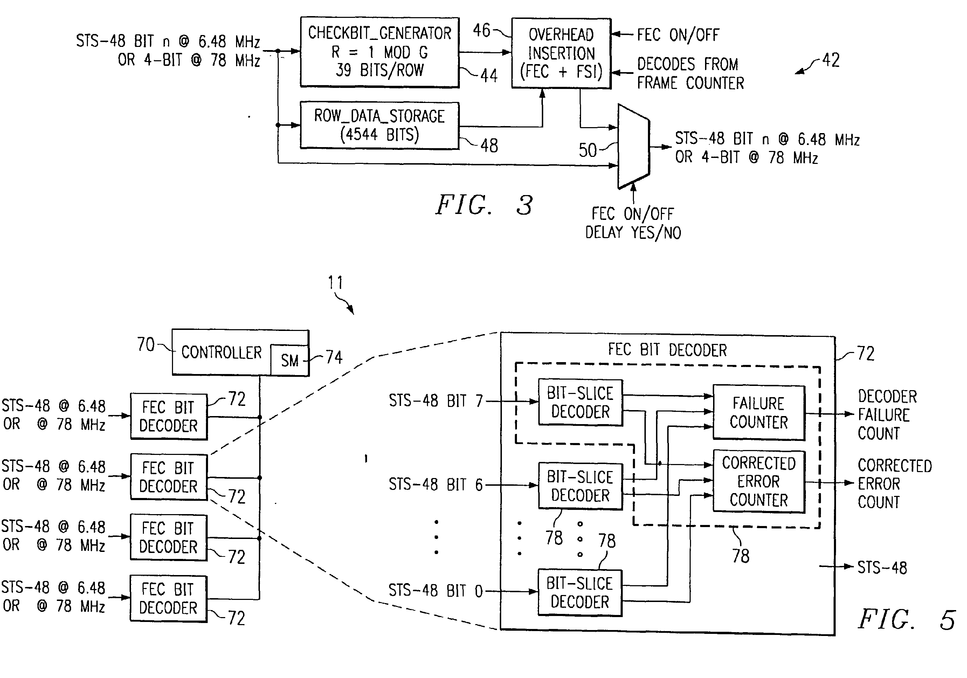

Referring to Figure 3, each bit-slice encoder 42 is comprised of a checkbit generator 44, an over-head insertion circuit 46, a row data storage 48, and an FEC on/off delay circuit 50.

Referring to Figure 4, each bit-slice encoder 42 is further illustrated to consist of a controller block 52, having a controller state machine block 54, the checkbit generator block 44, a FEC Status indication (FSI) bit insertion block 55, 2 different blocks to insert in checkbits 58, and a selection block 60. These blocks implement and meet the requirements of the Standard. The total delay through the encoding system 12 is about 14 microseconds. The controller 52 sends out signals to the checkbit generation 44 to shift in information bits, shift in zeros, shift out checkbits, and disable encoding of certain bits. The controller 52 also sends out the frame counter signals and end of row markers. The checkbit generator 44 generates the checkbits to be inserted in the section overhead (SOH) and line overhead (LOH). The 2 different insertion blocks 58 insert checkbits with minimum delay and minimum checkbit storage. A 1104x4 RAM 59 is used by the $2^{nd}$ checkbit insertion block to delay data. The controller state machine 54 implements the state machine requirements in the Standard. The data selection block 60 implements the different data selection modes in the Standard (1 = encoding on, 2 = encoding off with encoding delay, 3 = Encoding off without encoding delay).

**FEC Decoder top level design**

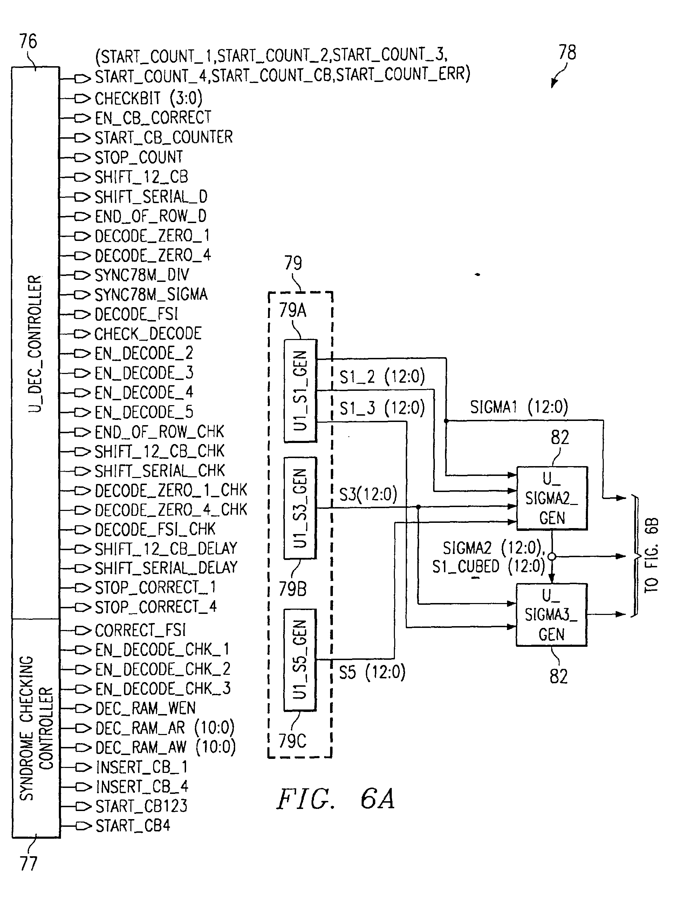

Referring now to Figure 5, the FEC decoder 11 is made up of a top level controller 70 and individual FEC bit decoders 72. Top level controller 70 has a state machine 74 for controlling the decoders 72 for sending the enable signals to the individual bit decoders 72. The total delay through the decoding system 14 is about 14.6 microseconds.

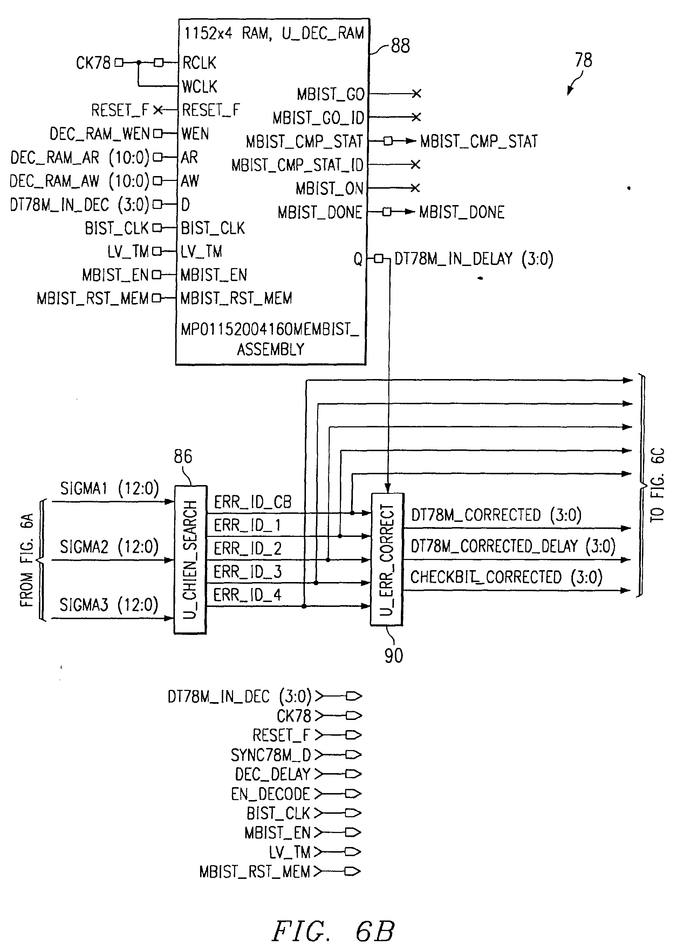

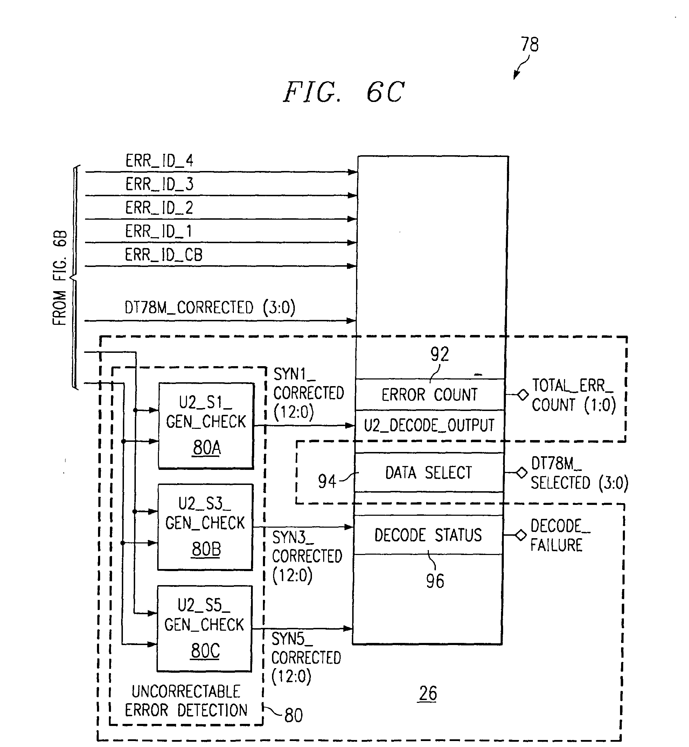

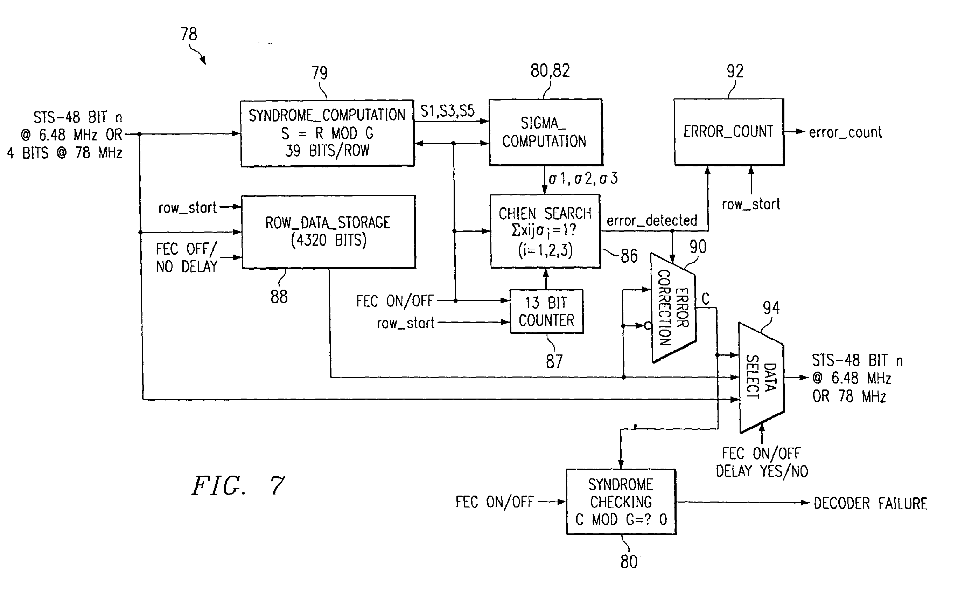

Referring to Figure 6 and Figure 7, each bit-sliced decoder 78 has a main controller 76, 3 syndrome generator blocks 79, for 3 syndrome checking blocks 80, a block 82 to calculate sigma 2, a block 84 to calculate sigma 3, a Chien search block 86, a counter 87, a storage block (1152x4 RAM) 88, an error correction block 90, an error counting block 92, a data selection block 94, and a decoder status block 96.

The main controller 76 sends out the signals to enable/disable the functions of the other blocks, except syndrome checking blocks 80. A controller 79 for syndrome checking blocks 80 generates the signals specific to enabling/disabling the syndrome checking functions 80. The syndrome generators 78 send the syndromes to the sigma calculation blocks 82 & 84, which contains discrete multiply, squaring, adding circuitry. The sigma results are sent to the Chien search 86, where it finds the roots of the error polynomial. The Chien search block 86 sends the error ID locations to the error correction block 90, which corrects both the delayed information and the checkbit errors (up to 3 errors). The error count block 92 counts the number of errors corrected by error correction block 90. The corrected information and check bits are sent to the syndrome checking blocks 80 to detect uncorrectable error conditions. The decode status block 96 will inform the upper level of this condition. There may be cases where the information is so errored that it is undetectable by even the syndrome checkers 80. It would be up to the B2 calculation to detect these errors, as shown in Figure 1A.

**Checkbit Generator for FEC encoding**

Referring now to Figure 1, the checkbit generator 14 implements the equation for R(X) from the Standard.

$$R(x) = I(x) \bmod G(x) = a_{38}\, x^{38} + ... + a_0$$

$$G(X) = G1(x) * G3(x) * G5(x).$$

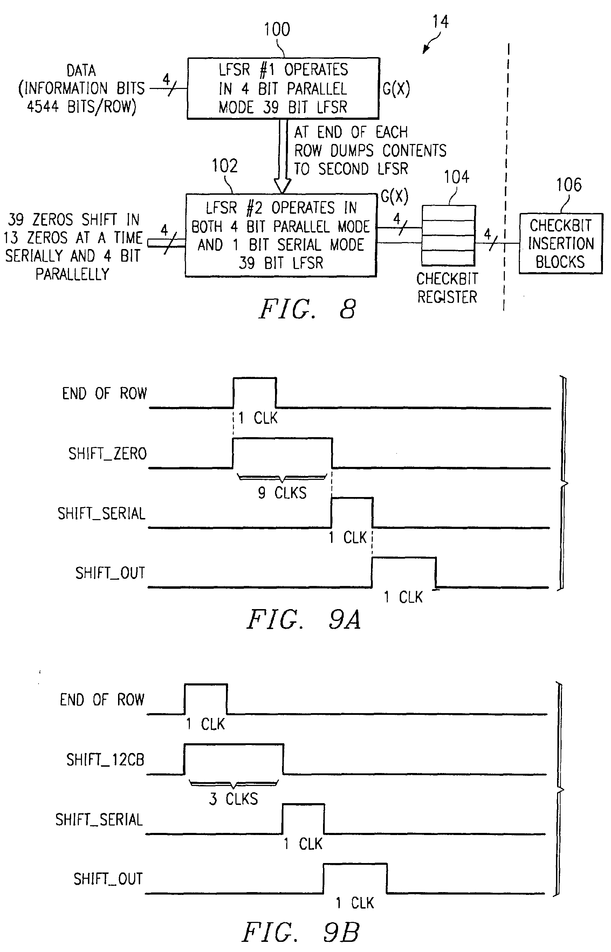

Checkbit generator 14 is shown in more detail in Figure 8 and Figure 9. Checkbit generator 14 is composed of LFSR's 100 & 102. Each LFSR can operate in both 4-bit parallel and 1 bit serial 39 bit modes. The LFSRs 100 and 102 work together to allow data to continuously be shifted in and checkbits to be generated. The first LFSR 100 shifts in the information bits. At the end of each row, after the information bits have been shifted in, the first LFSR 100 dumps its contents to the second LFSR 102, which immediately shifts in 39 zero-bits and does the modulus operation. The contents in the second LFSR 102 contains the 39 checkbits once the zero bits have been shifted in. Then, the checkbits are shifted out 4 bits at a time to checkbit register 104, which feeds a checkbit insertion block 106.

The serial circuitry for the LFSRs 100 and 102 are derived by multiplying and reducing the 3 smaller polynomial functions using $GF(2^{13})$ and modulus 2 mathematics. The parallel circuitry for the LFSRs 100 and 102 are functionally identical to the serial implementation. The timing for the signals of the checkbit generator 14 are depicted in Figure 9. The LFSRs that perform these functions are Generators 44. Controller 52 generates these signals including SHIFT_12_ZERO for the encoder.

**FEC Decoder For Fed Decoding**

**Syndrome Generators**

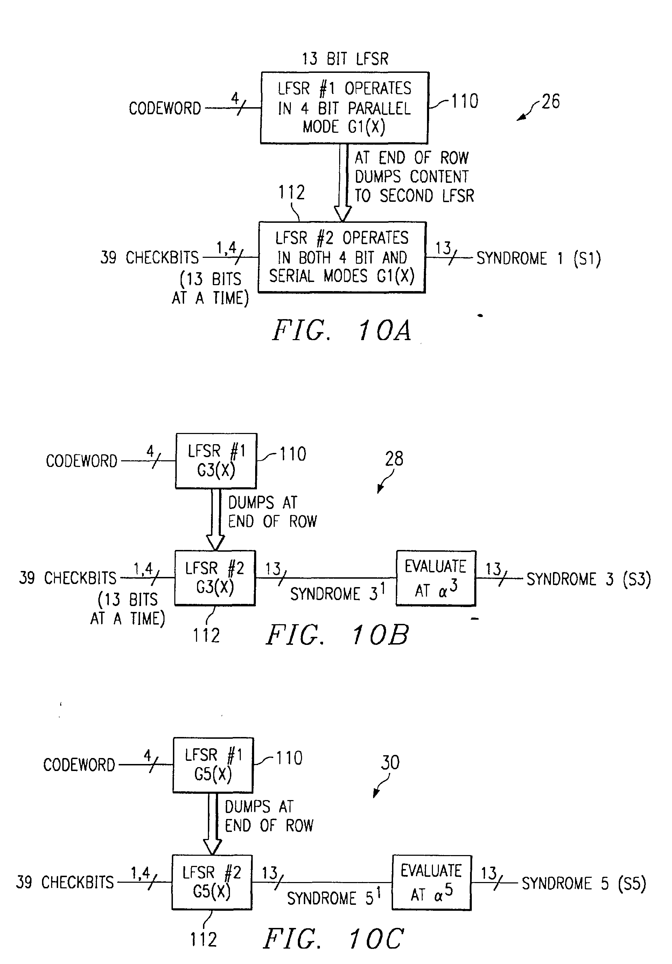

Referring now to Figure 10 A, Figure 10B, and figure 10C, the syndrome generators 26, 28 and 30 shown in Figure 1B implement the following equations:

$$S_1 = r(\alpha) \bmod G1(\alpha)$$

$$S_3 = r(\alpha^3) \bmod G3(\alpha^3)$$

$$S_5 = r(\alpha^5) \bmod G5(\alpha^5)$$

The syndrome generators 26, 28 and 30 are made up of 3 blocks that calculate Syndrome 1(S1), Syndrome 3 (S3), and Syndrome 5 (S5). Each block is composed of two linear feedback shift registers (LFSR) 110 and 112. Each LFSR 110 and 112 can operate in both 4-bit parallel and 1-bit serial 39 bit modes. The 2 LFSRs 110 and 112 work together to allow data to continuously be shifted in and a syndrome to be generated. The first LFSR 110 shifts in the information bits. At the end of each row, after the information bits have been shifted in, the first LFSR 110 dumps its contents to the second LFSR 112, which shifts in the 39 checkbits which does the modulus operation. The contents in the second LFSR 112 contains the syndrome once the checkbits have been shifted in. Then, the checkbits are shifted out 4 bits at a time.

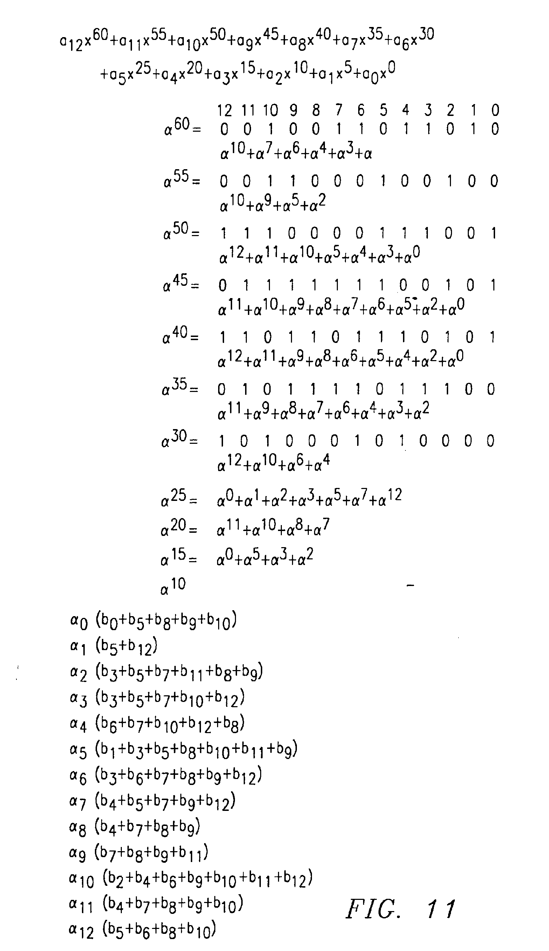

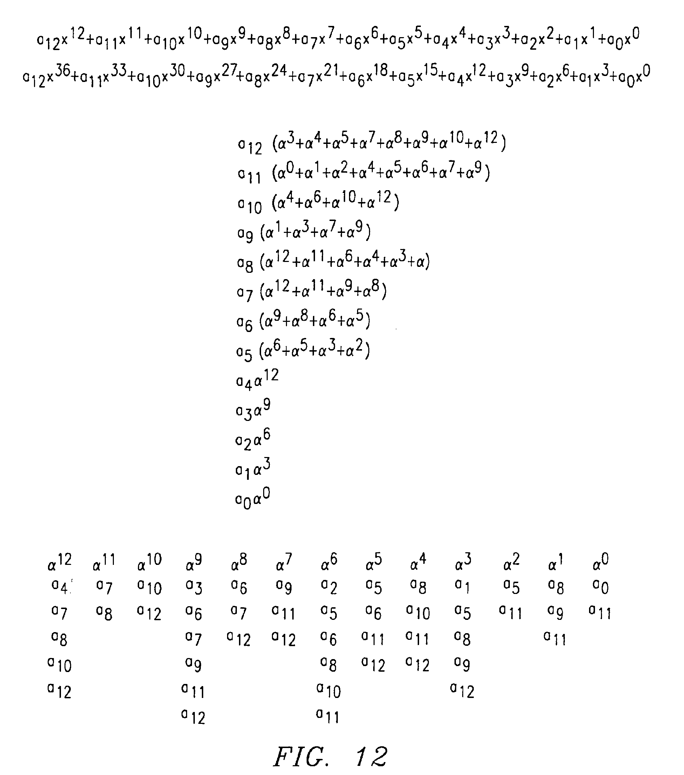

Referring to Figures 11&12, for calculations S3 and S5, the syndromes in $\alpha^3$ and $\alpha^5$ are solved as follows. The timing for the signals of the syndrome generator are depicted in Figure 9. The LFSR's that perform these signals are shown at 79A, 79B, 79C and at 80A, 80B and 80C. Controllers 76 and 77 generate these timing signals, where signal SHIFT_12_CB is used here.

**FEC Sigma Calculation for BCH-3**

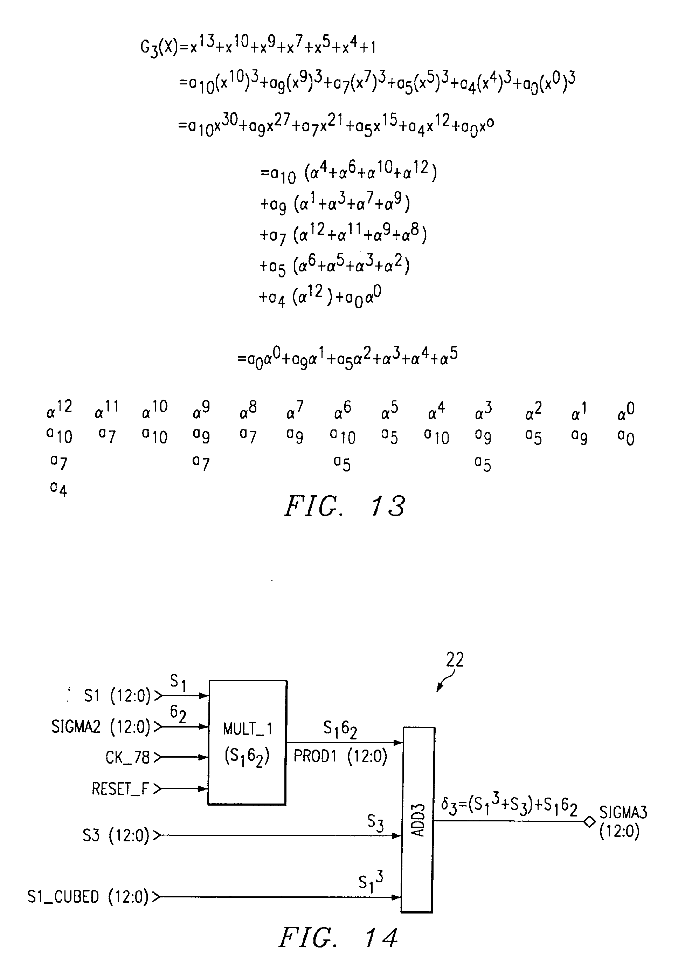

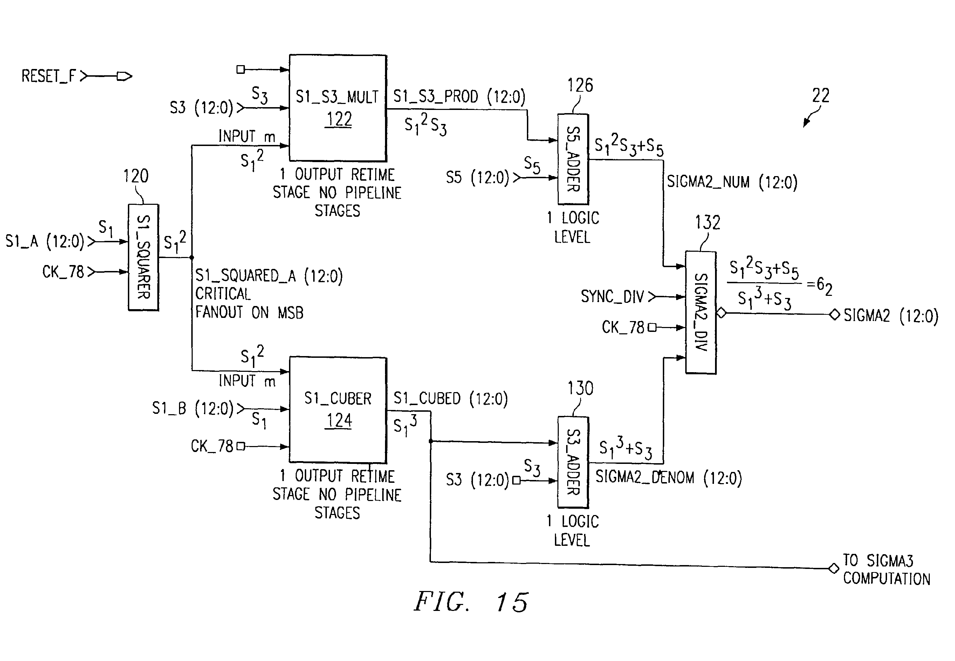

Referring to figures 14 and 15, the sigma calculation for FEC decoding of the BCH-3 code is done with discrete mathematics units and uses parallel structure to accomplish the computation with low latency.

It implements the equations for $\sigma_1$, $\sigma_2$, and $\sigma_3$:

$$\sigma_1 = S_1$$

$$\sigma_2 = (S_1{}^2 S_3 + S_5)/(S_1{}^3 + S_3)$$

$$\sigma_3 = (S_1{}^3 + S_3) + S_1 \sigma_2$$

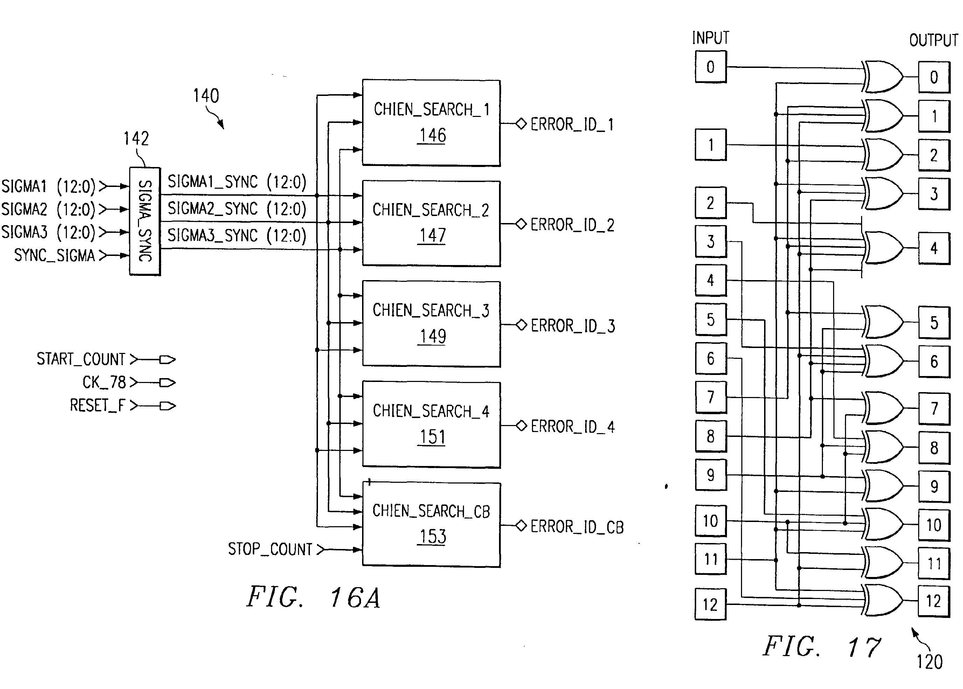

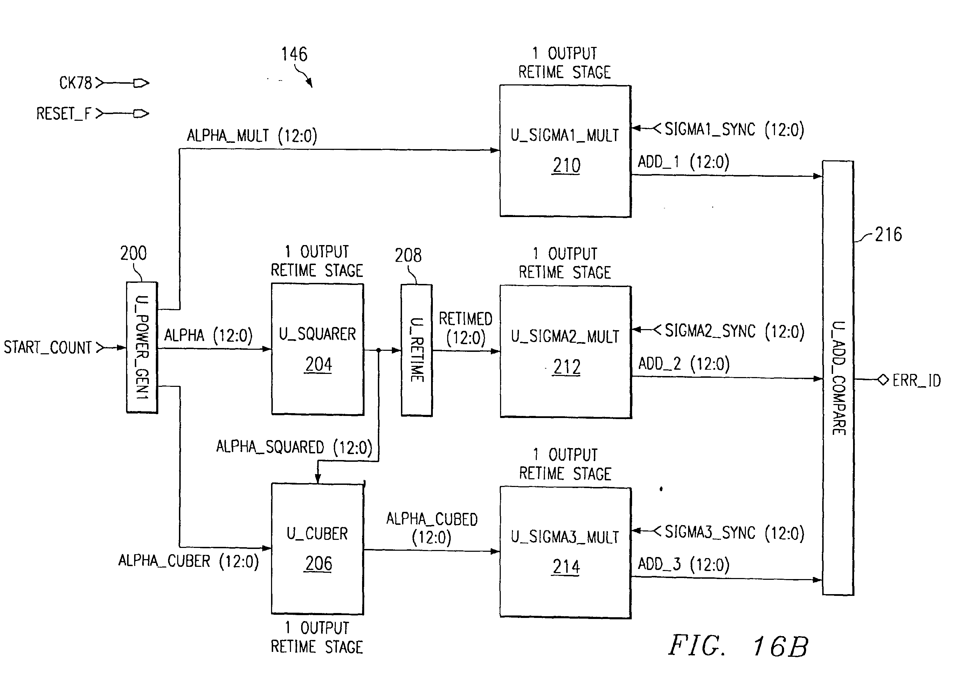

The present invention implements a custom multiplier and squarer to do multiplication, squaring, and cubing as shown in more detail in Figure 16, 17 and 18. The cubing is done by multiplying the output of the squarer and one of it's inputs. The addition is done using XOR gates. The division circuit is based on the circuit proposed in Yuh-Tsuen Horng and Shyue-Win Wei, "Fast Inverters and Dividers for Finite Field GF($2^m$)", 1994 IEEE, the teachings of which are incorporated herein by reference.

Still referring to Figure 15, the sigma2 and sigma3 computation circuit 22 is also seen to include an S1 cuber circuit 124. The S1*S3 multiplier 122 provides a product output to the S5 adder circuit 126, and the S cuber circuit 124 outputs its cubed output to a S3 adder circuit 130. The S cuber circuit 124 is made up of a multiplier that takes its inputs and the result of the squarer circuit 120 receiving sigma 1. The adders 126 and 130 provide their outputs to a sigma 2 divider circuit 132, as shown.

Referring to Figure 15, the squarer 120 takes 2 inputs to be multiplied and outputs the results in 1 clock cycle. This solution is custom for GF($2^{13}$). For other powers, the same methodology can be implemented, but the resulting gates will be different. Refer to Figures 17 & 18 for detailed depictions of the Squarer circuit, the Multiplier circuit and the Cuber circuit.

### Error Correction for FEC decoding

Referring now to Figure 16A the present invention uses parallel Chien search blocks to search roots 4 bits at a time as shown at 140. This parallel scheme reduces latency and meets the 4-bit 78Mhz data rate used. The serial Chien search corrects the checkbits errors. The Chien search block implements the following equations.

From Eq. 2.6, using the Chien search for j, where j = 3833, 3834,...,8191

$$\text{Eq. 2.7} \qquad \sigma_1(\alpha^j) + \sigma_2(\alpha^j)^2 + \sigma_3(\alpha^j)^3 =? 1$$

If Eq. 2.7 = 1, then the bit at location 8192-j is inverted.

Still referring to Figure 16A, there is shown at 140 a Chien search error correction circuit. Circuit 140 is seen to include a sigma synchronizer circuit 142 having 3 outputs identified as sigma 1 sync, sigma 2 sync, and sigma 3 sync, which outputs are provided to a plurality of Chien search circuits shown at 146. Each Chien search circuit 146 provides a respective output shown as error ID.

As shown in Figure 16A, CHIEN_SEARCH_1 block 146, CHIEN_SEARCH_2 block 147, CHIEN_SEARCH_3 block 149, and CHIEN_SEARCH_4 block 151 generate Error Ids for both information bit errors and certain checkbit errors (checkbits for rows 3,5,6,7,8, and 9). CHIEN_SEARCH_1 block 146 corrects errors in bit position 3 of the data. CHIEN_SEARCH_2 147 corrects errors in bit position 2 of the data. CHIEN_SEARCH_3 block 149 corrects errors in bit position 1 of the data. CHIEN_SEARCH_4 block 151 corrects errors in bit position 0 of the data.

Referring to Figure 16B, the lower hierachy of the CHIEN_SEARCH_1 block is shown. It is shown that block 200 generates the Galois Field vectors (for information bits and checkbits). POWER_GEN1 block 200 generates the Galois field vectors for the information bits locations and for the checkbit locations for rows 3, 5,6,7,8, and 9 to send to the mathematical units SQUARER block 204, CUBER block 206, SIGMA1_MULT block 210, SIGMA2_MULT block 212, and SIGMA3_MULT block 214. The results from sigma multiplier blocks 210, 212, and 214 are sent to the ADD_COMPARE block 216 which generates the error_id. The CUBER block 206 is made up of a multiplier block that takes in the squared result from the SQUARER block 204. The mathematical units block 204,206,210,212,214, and 216 implement the Chien Search equation Eq. 2.7. The lower hierarchy of each of CHIEN_SEARCH_2 block 147, CHIEN_SEARCH_3 block 149, and CHIEN_SEARCH_4 block 151 are all similar to CHIEN_SEARCH_1 146 shown in Figure 16B, except they generate different vector locations pertaining to their specific bit position in the data. The error ids generated are used by the error correction block 90 to correct the delayed data as they are shifted through the 1152x4 RAM 88.

Figure 16C shows the lower hierarchy of the CHIEN_SEARCH_CB block 153 which generates Error Ids for all checkbit errors. There is shown in Figure 16C a POWER_GEN_CB block 218 that generates serial Galois Field vectors. A SQUARER block 220, a CUBER block 222, a MULTIPLIER block 226, 228, 230, and an ADD_COMPARE block 216 implements the Chien Search equation for each Galois Field vector generated that tests the location for the error roots. The CUBER block 222 is made up of a multiplier block that takes in the squared result from the SQUARER block 220. The Error Ids provided by CHIEN_SEARCH_CB block 153 are used to correct the stored checkbits for use in error correction failure detection syndrome checking blocks 80. The corrected stored checkbits for rows 1, 2, and 4 are inserted into the overhead as the data is shifted through 88.

### Error correction failure detection for FEC decoding

The "corrected" information bits and checkbits are fed into the parallel syndrome 80 generator to see if the syndromes are zero. If the syndromes are not zero, the error correction is declared a failure. This is a sure and simple method to determine if there are more than 3 errors (max number of errors correctable). Although this failure detection module 26 can't catch all cases of error correction failure, this approach is very reliable to predict when error correction has failed. The checking circuits 80 are the same circuits used for syndrome generator 79, so there is reuse and low latency associated with this method. If the number of total error ids ( both information and checkbits) are more than three for a particular row, an error correction failure is declared by checker 26 because there should be three or less error ids generated for a particular row. Since CHIEN_SEARCH_CB block 153 generates error_ids for all checkbits and the other CHIEN_SEARCHs blocks 146, 147, 149 and 151 generate error_ids for checkbits in rows 3,5,6,7,8, and 9. Error count Block 92 ensures that the checkbit error_ids aren't counted twice for the same row. Thus, only the error_ids generated by CHIEN_SEARCH_CB Block 153 are added to the other error_ids for rows 1,2, and 4.

**Parallel in-Parallel out GF($2^{13}$) optimized Squarer**

Referring now to Figure 15, to implement the sigma 2 calculations 22 and the Chien search of Figure 16B, the GF($2^{13}$) vectors are squared by a squarer 120.

For comparison:

(Jain, Surendra K. and Parhi, Keshab K. "Low Latency Standard Basis GF ($2^M$) Multiplier and Squarer Architectures", IEEE 1995.)

Jain and Parhi's solution for the squarer:

Number of basic cells:     m(m/2)=13(13/2)=84.50.

Latency=m/2=6.5=7 clock cycles.

Each cell takes three 2 input AND, three 2-input XOR gates and four 1 bit latches. Total AND gates for GF ($2^{13}$) > 253, XOR gates> 253. 338 1-bit latches.

The present invention: Total: 23 XOR gates, 13 latches. Latency=1 clock cycle because of the lower number of gates as simplified design. Referring to Figure 18 there is illustrated the calculations for the squarer 120.

To make it feasible in VLSI implementation, a gate optimized, latency squaring circuit is used.

**Parallel in-Parallel out GF($2^{13}$) optimized Multiplier**

To implement the sigma calculations and Chien search, the GF($2^{13}$) vectors are multiplied by a multiplier 122. The present invention has a multiplier 122 that takes 2 inputs to be multiplied and outputs the results multiplication in GF($2^{13}$) in 1 clock cycle.

For comparison:

(Jain, Surendra K. and Parhi, Keshab K. "Low Latency Standard Basis GF ($2^M$) Multiplier and Squarer Architectures", IEEE 1995.)

Jain and Parhi's solution for the multiplier:

number of basic cells: $M^2 = 169$

Latency = m+1 = 14 clock cycles

The basic cell has two 2-input AND gates, two 2-input XOR gates, and three 1-bit latches. Total AND gates for GF($2^{13}$)= 338 , XOR gates= 338, and 507 1-bit latches.

The present invention: Total: 368 XOR/AND gates, 13 latches. Latency=1 clock cycle because we are not using a pipelined structure.

The multiplier can also have a 2 stage pipelined to meet more stringent timing requirements. It would take 2 clock cycles to complete 1 multiplication. Referring to Figure 19, the 1st stage is TERMS(0-24) and the 2nd stage is the RESULT_M(0-12).

Referring now to Figure 19, there is illustrated the calculations for the multiplier circuit 122, including both intermediately terms and the reduced results of the GF ($2^{13}$).

### G1(x) LFSR used in FEC decoding

Referring now to Figure 20, there is depicted a circuit 140 that implements the 4-bit parallel LFSR for:

$$G1(x)= x^{13} + x^4 + x^3 + x + 1$$

This LFSR implements the G1 (x) function according to Standard, and runs at 78 Mhz and has 4 bit-parallel inputs in the example. The circuit implements 4-bit parallel linear shift register (LFSR) for the circuits in the syndrome generators for implementing FEC according to the present invention.

### G3(x) LFSR used in FEC decoding

Referring now to Figure 21, there is depicted a circuit 150 that implements the 4-bit parallel LFSR for:

$$G3(x)= x^{13} + x^{10} + x^9 + x^7 + x^5 + x^4 + 1$$

This LFSR implements the G3 (x) function according to Standard, and runs at 78 Mhz and has 4 bit-parallel inputs. The circuit implements 4-bit parallel linear shift register (LFSR) for the circuits in the syndrome generators for implementing FEC according to the present invention.

### G5(x) LFSR used in FEC decoding

Referring now to Figure 22, there is depicted a circuit 160 that implements the 4-bit parallel LFSR for:

$$G5(x)= x^{13} + x^{11} + x^8 + x^7 + x^4 + x + 1$$

This LFSR implements the G5 (x) function according to Standard, and runs at 78 Mhz and has 4 bit-parallel inputs. The circuit implements 4-bit parallel linear shift register (LFSR) for the circuits in the checkbit generator for implementing FEC according to the present invention.

### G(x) LFSR used in FEC encoding

Referring now to Figure 23, there is depicted a circuit 16 that implements the 4-bit parallel LFSR for:

$$G(X)=G1(X)*G3(X)*G5(X)$$

This LFSR implements the GX (x) function according to Standard, and runs at 78 Mhz and has 4 bit-parallel inputs. The circuit implements 4-bit parallel linear shift register (LFSR) for the circuits in the checkbit generator for implementing FEC according to the present invention. The calculations for the 4-bit parallel LFSR is depicted in Figure 24.

### Galois Field (GF $2^{13}$) "increment by 4" vector generator circuit used in FEC decoding

Referring now to Figure 25, there 4 Galois Field generators generally at 170. Since the FEC decoder 11 is operating at 78 Mhz in 4-bit parallel mode, the circuits generating 4 GF$2^{13}$ vectors and feeding the 4 Chien Search circuits (used in error correction) operate in parallel to search for the roots of the error polynomial.
This circuit 170 is used to create the 4 vector generators that increment by 4 instead of incrementing by 1. This circuit 170 is a variant of the basic GF $2^{13}$ vector generator that is made up of a linear feedback shift register. It increments by 4 instead of incrementing by 1.

### Reverse GF($2^{13}$) serial vector generator for FEC decoding

Referring now to Figure 26, there is shown at 180 a circuit to generate serial GF($2^{13}$) vectors for the error correction of the checkbits. This circuit 180 implements the reverse serial LFSR for:

$$G1(x) = x^{13} + x^4 + x^3 + x + 1.$$

The referenced Standard T1X1.5/99-218R3 provides additional detailed information for use and operation of the present invention, including depicting the location of in-band FEC checkbits, location of status/control bits, code block definition and interleaving, the STS-N signal where N = 192, the FEC status indication (FSI), FSI coding for STS-48 signals, STS-N signal where N= 192, B1 calculation at the encoder and decoder, and B2 calculation at the encoder and decoder. In addition, FEC activation and deactivation operational states are provided, along with FEC status indication FSI, line AIS interaction with FEC, and associated Figures and graphs. This Standard further provides clarity and integration of the present invention into the overall standard and which meets all requirements of this standard.

Though the invention has been described with respect to a specific preferred embodiment, many variations and modifications will become apparent to those skilled in the art upon reading the present application. It is therefore the intention that the appended claims be interpreted as broadly as possible in view of the prior art to include all such variations and modifications.

**Claims**

1. A multiplier circuit for use in a decoder, comprising:

   a clock generating clock cycles at a first frequency; and

   a multiplier module coupled to said clock and adapted to receive 2 inputs, said multiplier circuit multiplying said 2 inputs using 1 said clock cycle to achieve a latency of only 1 clock cycle.

2. The multiplier circuit as specified in Claim 1 wherein said 2 inputs are polynomials.

3. The multiplier circuit as specified in Claim 1 wherein said 2 inputs are Galois Field vectors.

4. the multiplier circuit as specified in Claim 1 wherein said 2 inputs are GF ($2^{13}$) vectors.

5. The multiplier circuit as specified in Claim 1 wherein said clock operates at 78 Mhz.

6. The multiplier circuit as specified in Claim 1 wherein said inputs are associated with either OC-48 or OC-192 data.

7. The multiplier circuit as specified in Claim 1 wherein said multiplier circuit conforms to SDH Standard ITU-T.G. 707/Y.1322.

8. The multiplier circuit as specified in Claim 1 wherein said multiplier module is implemented using XOR/AND gates and latches.

9. The multiplier circuit as specified in Claim 2 wherein said multiplier is implemented in only XOR/AND gates and latches.

10. The multiplier circuit as specified in Claim 1 wherein said multiplier multiplies said 2 inputs using 2 clock cycles.

11. A multiplier circuit for use in a decoder, comprising:

    a clock generating clock cycles at a first frequency; and

    a multiplier module coupled to said clock and adapted to receive 2 inputs, said multiplier circuit multiplying said 2 inputs using a pipeline and using 2 said clock cycles.

12. The multiplier circuit as specified in Claim 11 wherein said 2 inputs are polynomials.

13. The multiplier circuit as specified in Claim 11 wherein said 2 inputs are Galois Field vectors.

14. The multiplier circuit as specified in Claim 11 wherein said 2 inputs are GF ($2^{13}$) vectors.

**15.** The multiplier circuit as specified in Claim 11 wherein said clock operates at 78 Mhz.

**16.** The multiplier circuit as specified in Claim 11 wherein said inputs are associated with either OC-48 or OC-192 data.

**17.** The multiplier circuit as specified in Claim 11 wherein said multiplier circuit conforms to SDH Standard ITU-T.G. 707/Y.1322.

**18.** The multiplier circuit as specified in Claim 11 wherein said multiplier module is implemented using XOR/AND gates and latches.

**19.** The multiplier circuit as specified in Claim 12 wherein said multiplier is implemented in only XOR/AND gates and latches.

**20.** The multiplier circuit as specified in Claim 11 wherein said multiplier multiplies said 2 inputs using 2 clock cycles.

FIG. 1A

EP 1 217 751 A2

# FIG. 1B

GEN

12

E-FEC
E-FEC
E-FEC
E-FEC
E-FEC

HS LINE IFC

SONET MX

TOH INSERT

HITLESS SWITCH

MTX DMX

HS MTX IFC

MTX DMX

HS MTX IFC

P P P P P P P P P P P P P P P P P P P P P P P P P P P P P P P P

@2.5 GHz ← 4

@622 MHz ← 16

128 @78 MHz

1536 @6.48 MHz

1536 @6.48 MHz

1536 @6.48 MHz

1536 @6.48 MHz

1536 @6.48 MHz

128 @78 MHz

4 @2.5 GHz

16 @622 MHz

1536 @6.48 MHz

128 @78 MHz

4 @2.5 GHz

16 @622 MHz

FPGA MM IFC

STATUS/CONTROL

CTL PORT

STATUS PORT

TOH PORT

POH PORT

MTOH PORT

FIG. 1C

FIG. 1D

FIG. 2

STS-48 BIT n @ 6.48 MHz
OR 4-BIT @ 78 MHz

CHECKBIT_GENERATOR
R = 1 MOD G
39 BITS/ROW

46

OVERHEAD
INSERTION
(FEC + FSI)

FEC ON/OFF

DECODES FROM
FRAME COUNTER

42

44

ROW_DATA_STORAGE
(4544 BITS)

48

50

STS-48 BIT n @ 6.48 MHz
OR 4-BIT @ 78 MHz

FEC ON/OFF
DELAY YES/NO

*FIG. 3*

11

70

CONTROLLER  SM

74

STS-48 @ 6.48
OR @ 78 MHz

FEC BIT
DECODER

72

STS-48 @ 6.48
OR @ 78 MHz

FEC BIT
DECODER

72

STS-48 @ 6.48
OR @ 78 MHz

FEC BIT
DECODER

72

STS-48 @ 6.48
OR @ 78 MHz

FEC BIT
DECODER

72

FEC BIT DECODER

72

STS-48 BIT 7

BIT-SLICE
DECODER

FAILURE
COUNTER

DECODER
FAILURE
COUNT

STS-48 BIT 6

BIT-SLICE
DECODER

CORRECTED
ERROR
COUNTER

CORRECTED
ERROR
COUNT

78

78

78

STS-48 BIT 0

BIT-SLICE
DECODER

STS-48

*FIG. 5*

FIG. 4

EP 1 217 751 A2

76

78

(START_COUNT_1,START_COUNT_2,START_COUNT_3,
START_COUNT_4,START_COUNT_CB,START_COUNT_ERR)
CHECKBIT (3:0)
EN_CB_CORRECT
START_CB_COUNTER
STOP_COUNT
SHIFT_12_CB
SHIFT_SERIAL_D
END_OF_ROW_D
DECODE_ZERO_1
DECODE_ZERO_4
SYNC78M_DIV
SYNC78M_SIGMA
DECODE_FSI
CHECK_DECODE
EN_DECODE_2
EN_DECODE_3
EN_DECODE_4
EN_DECODE_5
END_OF_ROW_CHK
SHIFT_12_CB_CHK
SHIFT_SERIAL_CHK
DECODE_ZERO_1_CHK
DECODE_ZERO_4_CHK
DECODE_FSI_CHK
SHIFT_12_CB_DELAY
SHIFT_SERIAL_DELAY
STOP_CORRECT_1
STOP_CORRECT_4
CORRECT_FSI
EN_DECODE_CHK_1
EN_DECODE_CHK_2
EN_DECODE_CHK_3
DEC_RAM_WEN
DEC_RAM_AR (10:0)
DEC_RAM_AW (10:0)
INSERT_CB_1
INSERT_CB_4
START_CB123
START_CB4

U_DEC_CONTROLLER

SYNDROME CHECKING CONTROLLER

77

79

79A

U1_S1_GEN

S1_2 (12:0)

S1_3 (12:0)

SIGMA1 (12:0)

82

U_SIGMA2_GEN

U1_S3_GEN

S3(12:0)

SIGMA2 (12:0),
S1_CUBED (12:0)

TO FIG. 6B

79B

U1_S5_GEN

S5 (12:0)

U_SIGMA3_GEN

82

79C

*FIG. 6A*

*FIG. 6B*

78

FIG. 6C

FIG. 7

100

DATA
(INFORMATION BITS
4544 BITS/ROW) — 4/ →

| LFSR #1 OPERATES IN 4 BIT PARALLEL MODE 39 BIT LFSR | G(X) |

14

AT END OF EACH
ROW DUMPS CONTENTS
TO SECOND LFSR

102

39 ZEROS SHIFT IN
13 ZEROS AT A TIME
SERIALLY AND 4 BIT
PARALLELLY

4/

| LFSR #2 OPERATES IN BOTH 4 BIT PARALLEL MODE AND 1 BIT SERIAL MODE 39 BIT LFSR | G(X) |

4/

104

CHECKBIT
REGISTER

4/

106

CHECKBIT
INSERTION
BLOCKS

FIG. 8

END OF ROW ⎍ 1 CLK

SHIFT_ZERO ⎍⎍⎍ 9 CLKS

SHIFT_SERIAL ⎍ 1 CLK

SHIFT_OUT ⎍ 1 CLK

FIG. 9A

END OF ROW ⎍ 1 CLK

SHIFT_12CB ⎍⎍⎍ 3 CLKS

SHIFT_SERIAL ⎍ 1 CLK

SHIFT_OUT ⎍ 1 CLK

FIG. 9B

24

13 BIT LFSR

CODEWORD —4/— LFSR #1 OPERATES IN 4 BIT PARALLEL MODE G1(X) —110    /—26

AT END OF ROW DUMPS CONTENT TO SECOND LFSR

112

39 CHECKBITS —1,4/— LFSR #2 OPERATES IN BOTH 4 BIT AND SERIAL MODES G1(X) —13/— SYNDROME 1 (S1)

(13 BITS AT A TIME)

*FIG. 10A*

CODEWORD —4/— LFSR #1 G3(X) —110    28

DUMPS AT END OF ROW

39 CHECKBITS —1,4/— LFSR #2 G3(X) —13/— EVALUATE AT $\alpha^3$ —13/— SYNDROME 3 (S3)

(13 BITS AT A TIME)    SYNDROME $3^1$

112

*FIG. 10B*

CODEWORD —4/— LFSR #1 G5(X) —110    30

DUMPS AT END OF ROW

39 CHECKBITS —1,4/— LFSR #2 G5(X) —13/— EVALUATE AT $\alpha^5$ —13/— SYNDROME 5 (S5)

SYNDROME $5^1$

112

*FIG. 10C*

$$a_{12}x^{60}+a_{11}x^{55}+a_{10}x^{50}+a_9x^{45}+a_8x^{40}+a_7x^{35}+a_6x^{30}$$
$$+a_5x^{25}+a_4x^{20}+a_3x^{15}+a_2x^{10}+a_1x^5+a_0x^0$$

|       | 12 | 11 | 10 | 9 | 8 | 7 | 6 | 5 | 4 | 3 | 2 | 1 | 0 |
|-------|----|----|----|---|---|---|---|---|---|---|---|---|---|
| $\alpha^{60}=$ | 0 | 0 | 1 | 0 | 0 | 1 | 1 | 0 | 1 | 1 | 0 | 1 | 0 |

$\alpha^{10}+\alpha^7+\alpha^6+\alpha^4+\alpha^3+\alpha$

| $\alpha^{55}=$ | 0 | 0 | 1 | 1 | 0 | 0 | 0 | 1 | 0 | 0 | 1 | 0 | 0 |

$\alpha^{10}+\alpha^9+\alpha^5+\alpha^2$

| $\alpha^{50}=$ | 1 | 1 | 1 | 0 | 0 | 0 | 0 | 1 | 1 | 1 | 0 | 0 | 1 |

$\alpha^{12}+\alpha^{11}+\alpha^{10}+\alpha^5+\alpha^4+\alpha^3+\alpha^0$

| $\alpha^{45}=$ | 0 | 1 | 1 | 1 | 1 | 1 | 1 | 1 | 0 | 0 | 1 | 0 | 1 |

$\alpha^{11}+\alpha^{10}+\alpha^9+\alpha^8+\alpha^7+\alpha^6+\alpha^5+\alpha^2+\alpha^0$

| $\alpha^{40}=$ | 1 | 1 | 0 | 1 | 1 | 0 | 1 | 1 | 1 | 0 | 1 | 0 | 1 |

$\alpha^{12}+\alpha^{11}+\alpha^9+\alpha^8+\alpha^6+\alpha^5+\alpha^4+\alpha^2+\alpha^0$

| $\alpha^{35}=$ | 0 | 1 | 0 | 1 | 1 | 1 | 1 | 0 | 1 | 1 | 1 | 0 | 0 |

$\alpha^{11}+\alpha^9+\alpha^8+\alpha^7+\alpha^6+\alpha^4+\alpha^3+\alpha^2$

| $\alpha^{30}=$ | 1 | 0 | 1 | 0 | 0 | 0 | 1 | 0 | 1 | 0 | 0 | 0 | 0 |

$\alpha^{12}+\alpha^{10}+\alpha^6+\alpha^4$

$\alpha^{25}= \quad \alpha^0+\alpha^1+\alpha^2+\alpha^3+\alpha^5+\alpha^7+\alpha^{12}$

$\alpha^{20}= \quad \alpha^{11}+\alpha^{10}+\alpha^8+\alpha^7$

$\alpha^{15}= \quad \alpha^0+\alpha^5+\alpha^3+\alpha^2$

$\alpha^{10}$

$\alpha_0 (b_0+b_5+b_8+b_9+b_{10})$

$\alpha_1 (b_5+b_{12})$

$\alpha_2 (b_3+b_5+b_7+b_{11}+b_8+b_9)$

$\alpha_3 (b_3+b_5+b_7+b_{10}+b_{12})$

$\alpha_4 (b_6+b_7+b_{10}+b_{12}+b_8)$

$\alpha_5 (b_1+b_3+b_5+b_8+b_{10}+b_{11}+b_9)$

$\alpha_6 (b_3+b_6+b_7+b_8+b_9+b_{12})$

$\alpha_7 (b_4+b_5+b_7+b_9+b_{12})$

$\alpha_8 (b_4+b_7+b_8+b_9)$

$\alpha_9 (b_7+b_8+b_9+b_{11})$

$\alpha_{10} (b_2+b_4+b_6+b_9+b_{10}+b_{11}+b_{12})$

$\alpha_{11} (b_4+b_7+b_8+b_9+b_{10})$

$\alpha_{12} (b_5+b_6+b_8+b_{10})$

*FIG. 11*

$$a_{12}x^{12}+a_{11}x^{11}+a_{10}x^{10}+a_9x^9+a_8x^8+a_7x^7+a_6x^6+a_5x^5+a_4x^4+a_3x^3+a_2x^2+a_1x^1+a_0x^0$$

$$a_{12}x^{36}+a_{11}x^{33}+a_{10}x^{30}+a_9x^{27}+a_8x^{24}+a_7x^{21}+a_6x^{18}+a_5x^{15}+a_4x^{12}+a_3x^9+a_2x^6+a_1x^3+a_0x^0$$

$a_{12}\ (\alpha^3+\alpha^4+\alpha^5+\alpha^7+\alpha^8+\alpha^9+\alpha^{10}+\alpha^{12})$

$a_{11}\ (\alpha^0+\alpha^1+\alpha^2+\alpha^4+\alpha^5+\alpha^6+\alpha^7+\alpha^9)$

$a_{10}\ (\alpha^4+\alpha^6+\alpha^{10}+\alpha^{12})$

$a_9\ (\alpha^1+\alpha^3+\alpha^7+\alpha^9)$

$a_8\ (\alpha^{12}+\alpha^{11}+\alpha^6+\alpha^4+\alpha^3+\alpha)$

$a_7\ (\alpha^{12}+\alpha^{11}+\alpha^9+\alpha^8)$

$a_6\ (\alpha^9+\alpha^8+\alpha^6+\alpha^5)$

$a_5\ (\alpha^6+\alpha^5+\alpha^3+\alpha^2)$

$a_4\alpha^{12}$

$a_3\alpha^9$

$a_2\alpha^6$

$a_1\alpha^3$

$a_0\alpha^0$

| $\alpha^{12}$ | $\alpha^{11}$ | $\alpha^{10}$ | $\alpha^9$ | $\alpha^8$ | $\alpha^7$ | $\alpha^6$ | $\alpha^5$ | $\alpha^4$ | $\alpha^3$ | $\alpha^2$ | $\alpha^1$ | $\alpha^0$ |
|---|---|---|---|---|---|---|---|---|---|---|---|---|
| $a_4$ | $a_7$ | $a_{10}$ | $a_3$ | $a_6$ | $a_9$ | $a_2$ | $a_5$ | $a_8$ | $a_1$ | $a_5$ | $a_8$ | $a_0$ |
| $a_7$ | $a_8$ | $a_{12}$ | $a_6$ | $a_7$ | $a_{11}$ | $a_5$ | $a_6$ | $a_{10}$ | $a_5$ | $a_{11}$ | $a_9$ | $a_{11}$ |
| $a_8$ | | | $a_7$ | $a_{12}$ | $a_{12}$ | $a_6$ | $a_{11}$ | $a_{11}$ | $a_8$ | | $a_{11}$ | |
| $a_{10}$ | | | $a_9$ | | | $a_8$ | $a_{12}$ | $a_{12}$ | $a_9$ | | | |
| $a_{12}$ | | | $a_{11}$ | | | $a_{10}$ | | | $a_{12}$ | | | |
| | | | $a_{12}$ | | | $a_{11}$ | | | | | | |

*FIG. 12*

27

$$G_3(X) = x^{13} + x^{10} + x^9 + x^7 + x^5 + x^4 + 1$$

$$= \sigma_{10}(x^{10})^3 + \sigma_9(x^9)^3 + \sigma_7(x^7)^3 + \sigma_5(x^5)^3 + \sigma_4(x^4)^3 + \sigma_0(x^0)^3$$

$$= \sigma_{10}x^{30} + \sigma_9 x^{27} + \sigma_7 x^{21} + \sigma_5 x^{15} + \sigma_4 x^{12} + \sigma_0 x^0$$

$$= \sigma_{10}(\alpha^4 + \alpha^6 + \alpha^{10} + \alpha^{12})$$
$$+ \sigma_9(\alpha^1 + \alpha^3 + \alpha^7 + \alpha^9)$$
$$+ \sigma_7(\alpha^{12} + \alpha^{11} + \alpha^9 + \alpha^8)$$
$$+ \sigma_5(\alpha^6 + \alpha^5 + \alpha^3 + \alpha^2)$$
$$+ \sigma_4(\alpha^{12}) + \sigma_0\alpha^0$$

$$= \sigma_0\alpha^0 + \sigma_9\alpha^1 + \sigma_5\alpha^2 + \alpha^3 + \alpha^4 + \alpha^5$$

| $\alpha^{12}$ | $\alpha^{11}$ | $\alpha^{10}$ | $\alpha^9$ | $\alpha^8$ | $\alpha^7$ | $\alpha^6$ | $\alpha^5$ | $\alpha^4$ | $\alpha^3$ | $\alpha^2$ | $\alpha^1$ | $\alpha^0$ |
|---|---|---|---|---|---|---|---|---|---|---|---|---|
| $\sigma_{10}$ | $\sigma_7$ | $\sigma_{10}$ | $\sigma_9$ | $\sigma_7$ | $\sigma_9$ | $\sigma_{10}$ | $\sigma_5$ | $\sigma_{10}$ | $\sigma_9$ | $\sigma_5$ | $\sigma_9$ | $\sigma_0$ |
| $\sigma_7$ | | | $\sigma_7$ | | | $\sigma_5$ | | | $\sigma_5$ | | | |
| $\sigma_4$ | | | | | | | | | | | | |

**FIG.  13**

**FIG.  14**

FIG. 15

EP 1 217 751 A2

FIG. 16A

FIG. 17

EP 1 217 751 A2

EP 1 217 751 A2

CK78 ▷──▷

RESET_F ▷──▷

146

ALPHA_MULT (12:0)

**1 OUTPUT
RETIME STAGE**

U_SIGMA1_MULT
**210**

◁ SIGMA1_SYNC (12:0)

ADD_1 (12:0)

216

200

U_POWER_GEN1

START_COUNT ▷

ALPHA (12:0)

**1 OUTPUT
RETIME STAGE**

U_SQUARER
**204**

208

U_RETIME

RETIMED
(12:0)

**1 OUTPUT
RETIME STAGE**

U_SIGMA2_MULT
**212**

◁ SIGMA2_SYNC (12:0)

ADD_2 (12:0)

U_ADD_COMPARE

◇ ERR_ID

ALPHA_SQUARED (12:0)

ALPHA_CUBER (12:0)

**1 OUTPUT
RETIME STAGE**

U_CUBER
**206**

ALPHA_CUBED
(12:0)

**1 OUTPUT
RETIME STAGE**

U_SIGMA3_MULT
**214**

◁ SIGMA3_SYNC (12:0)

ADD_3 (12:0)

**1 OUTPUT
RETIME STAGE**

*FIG. 16B*

FIG. 16C

THE GF($2^{13}$) VECTOR CAN BE WRITTEN AS

$$A = a_0 + a_1\alpha + a_2\alpha^2 + a_3\alpha^3 + a_4\alpha^4 + a_5\alpha^5 + a_6\alpha^6 + a_7\alpha^7 + a_8\alpha^8 + a_9\alpha^9 + a_{10}\alpha^{10} + a_{11}\alpha^{11} + a_{12}\alpha^{12}$$

$$A^2 = a_0 + a_1\alpha^2 + a_2\alpha^4 + a_3\alpha^6 + a_4\alpha^8 + a_5\alpha^{10} + a_6\alpha^{12} + a_7\alpha^{14} + a_8\alpha^{16} + a_9\alpha^{18} + a_{10}\alpha^{20} + a_{11}\alpha^{22} + a_{12}\alpha^{24}$$

WE NEED TO EXPAND TERMS FOR $\alpha^{14}$, $\alpha^{16}$, $\alpha^{18}$, $\alpha^{20}$, $\alpha^{22}$, $\alpha^{24}$
BREAKING THE EQUATION INTO C, D, E, F, G, H, I WE GET:

$$C = a_0 + a_1\alpha^2 + a_2\alpha^4 + a_3\alpha^6 + a_4\alpha^8 + a_5\alpha^{10} + a_6\alpha^{12}$$

$$D = a_7\alpha^{14} = a_7(\alpha + \alpha^2 + \alpha^4 + \alpha^5)$$

$$E = a_8\alpha^{16} = a_8(\alpha^3 + \alpha^4 + \alpha^6 + \alpha^7)$$

$$F = a_9\alpha^{18} = a_9(\alpha^5 + \alpha^6 + \alpha^8 + \alpha^9)$$

$$G = a_{10}\alpha^{20} = a_{10}(\alpha^7 + \alpha^8 + \alpha^{10} + \alpha^{11})$$

$$H = a_{11}\alpha^{22} = a_{11}(\alpha^0 + \alpha^1 + \alpha^3 + \alpha^4 + \alpha^9 + \alpha^{10} + \alpha^{11})$$

$$I = a_{12}\alpha^{24} = a_{12}(\alpha^1 + \alpha^3 + \alpha^4 + \alpha^6 + \alpha^{11} + \alpha^{12})$$

THE EXPANSION IS USING GF($2^{13}$) PROPERTIES

BY KNOWING $a_0$, $a_1$, $a_2$ ... $a_{12}$ ARE THE INPUT BITS OF THE NUMBER TO BE SQUARE
AND $\alpha^1$, $\alpha^2$, $\alpha^3$ ... $\alpha^{12}$ ARE THE BIT POSITION OF THE OUTPUT SQUARED RESULT

THE OUTPUT RESULT IS C+D+E+F+G+H+I
AFTER SIMPLIFYING THE LOGIC WE GET.

$O(0) = I(0) + I(11)$
$O(1) = I(7) + I(11) + I(12)$
$O(2) = I(1) + I(7)$
$O(3) = I(8) + I(11) + I(12)$
$O(4) = I(2) + I(7) + I(8) + I(11) + I(12)$
$O(5) = I(7) + I(9)$
$O(6) = I(3) + I(8) + I(9) + I(12)$
$O(7) = I(8) + I(10)$
$O(8) = I(4) + I(9) + I(10)$
$O(9) = I(9) + I(11)$
$O(10) = I(5) + (10) + I(11)$
$O(11) = I(10) + I(12)$
$O(12) = I(6) + I(11) + I(12)$

## FIG. 18

*FIG. 19*

```
TERMS(0)  <= (A(0) AND B(0));
TERMS(1)  <= (A(0) AND B(1)) XOR (A(1) AND B(0));
TERMS(2)  <= (A(0) AND B(2)) XOR (A(1) AND B(1)) XOR (A(2) AND B(0));
TERMS(3)  <= (A(0) AND B(3)) XOR (A(1) AND B(2)) XOR (A(2) AND B(1)) XOR (A(3) AND B(0));
TERMS(4)  <= (A(0) AND B(4)) XOR (A(1) AND B(3)) XOR (A(2) AND B(2)) XOR (A(3) AND B(1))
             XOR (A(4) AND B(0));
TERMS(5)  <= (A(0) AND B(5)) XOR (A(1) AND B(4)) XOR (A(2) AND B(3)) XOR (A(3) AND B(2))
             XOR (A(4) AND B(1)) XOR (A(5) AND B(0));
TERMS(6)  <= (A(0) AND B(6)) XOR (A(1) AND B(5)) XOR (A(2) AND B(4)) XOR (A(3) AND B(3))
             XOR (A(4) AND B(2)) XOR (A(5) AND B(1)) XOR (A(6) AND B(0));
TERMS(7)  <= (A(0) AND B(7)) XOR (A(1) AND B(6)) XOR (A(2) AND B(5)) XOR (A(3) AND B(4))
             XOR (A(4) AND B(3)) XOR (A(5) AND B(2)) XOR (A(6) AND B(1)) XOR (A(7) AND B(0));
TERMS(8)  <= (A(0) AND B(8)) XOR (A(1) AND B(7)) XOR (A(2) AND B(6)) XOR (A(3) AND B(5))
             XOR (A(4) AND B(4)) XOR (A(5) AND B(3)) XOR (A(6) AND B(2)) XOR (A(7) AND B(1))
             XOR (A(8) AND B(0));
TERMS(9)  <= (A(0) AND B(9)) XOR (A(1) AND B(8)) XOR (A(2) AND B(7)) XOR (A(3) AND B(6))
             XOR (A(4) AND B(5)) XOR (A(5) AND B(4)) XOR (A(6) AND B(3)) XOR (A(7) AND B(2))
             XOR (A(8) AND B(1)) XOR (A(9) AND B(0));
TERMS(10) <= (A(0) AND B(10)) XOR (A(1) AND B(9)) XOR (A(2) AND B(8)) XOR (A(3) AND B(7))
             XOR (A(4) AND B(6)) XOR (A(5) AND B(5)) XOR (A(6) AND B(4)) XOR (A(7) AND B(3))
             XOR (A(8) AND B(2)) XOR (A(9) AND B(1)) XOR (A(10) AND B(0));
TERMS(11) <= (A(0) AND B(11)) XOR (A(1) AND B(10)) XOR (A(2) AND B(9)) XOR (A(3) AND B(8))
             XOR (A(4) AND B(7)) XOR (A(5) AND B(6)) XOR (A(6) AND B(5)) XOR (A(7) AND B(4))
             XOR (A(8) AND B(3)) XOR (A(9) AND B(2)) XOR (A(10) AND B(1)) XOR (A11) AND B(0));
TERMS(12) <= (A(0) AND B(12)) XOR (A(1) AND B(11)) XOR (A(2) AND B(10)) XOR (A(3) AND B(9))
             XOR (A(4) AND B(8)) XOR (A(5) AND B(7)) XOR (A(6) AND B(6)) XOR (A(7) AND B(5))
             XOR (A(8) AND B(4)) XOR (A(9) AND B(3)) XOR (A(10) AND B(2)) XOR (A(11) AND B(1))
             XOR (A(12) AND B(0));
TERMS(13) <= (A(1) AND B(12)) XOR (A(2) AND B(11)) XOR (A(3) AND B(10)) XOR (A(4) AND B(9))
             XOR (A(5) AND B(8)) XOR (A(6) AND B(7)) XOR (A(7) AND B(6)) XOR (A(8) AND B(5))
             XOR (A(9) AND B(4)) XOR (A(10) AND B(3)) XOR (A(11) AND B(2)) XOR (A(12) AND B(1));
TERMS(14) <= (A(2) AND B(12)) XOR (A(3) AND B(11)) XOR (A(4) AND B(10)) XOR (A(5) AND B(9))
             XOR (A(6) AND B(8)) XOR (A(7) AND B(7)) XOR (A(8) AND B(6)) XOR (A(9) AND B(5))
             XOR (A(10) AND B(4)) XOR (A(11) AND B(3)) XOR (A(12) AND B(2));
TERMS(15) <= (A(3) AND B(12)) XOR (A(4) AND B(11)) XOR (A(5) AND B(10)) XOR (A(6) AND B(9))
             XOR (A(7) AND B(8)) XOR (A(8) AND B(7)) XOR (A(9) AND B(6)) XOR (A(10) AND B(5))
             XOR (A(11) AND B(4)) XOR (A(12) AND B(3));
TERMS(16) <= (A(4) AND B(12)) XOR (A(5) AND B(11)) XOR (A(6) AND B(10)) XOR (A(7) AND B(9))
             XOR (A(8) AND B(8)) XOR (A(9) AND B(7)) XOR (A(10) AND B(6)) XOR (A(11) AND B(5))
             XOR (A(12) AND B(4));
TERMS(17) <= (A(5) AND B(12)) XOR (A(6) AND B(11)) XOR (A(7) AND B(10)) XOR (A(8) AND B(9))
             XOR (A(9) AND B(8)) XOR (A(10) AND B(7)) XOR (A(11) AND B(6)) XOR (A(12) AND B(5));
TERMS(18) <= (A(6) AND B(12)) XOR (A(7) AND B(11)) XOR (A(8) AND B(10)) XOR (A(9) AND B(9))
             XOR (A(10) AND B(8)) XOR (A(11) AND B(7)) XOR (A(12) AND B(6));
TERMS(19) <= (A(7) AND B(12)) XOR (A(8) AND B(11)) XOR (A(9) AND B(10)) XOR (A(10) AND B(9))
             XOR (A(11) AND B(8)) XOR (A(12) AND B(7));
TERMS(20) <= (A(8) AND B(12)) XOR (A(9) AND B(11)) XOR (A(10) AND B(10)) XOR (A(11) AND B(9))
             XOR (A(12) AND B(8));
TERMS(21) <= (A(9) AND B(12)) XOR (A(10) AND B(11)) XOR (A(11) AND B(10)) XOR (A(12) AND B(9));
TERMS(22) <= (A(10) AND B(12)) XOR (A(11) AND B(11)) XOR (A(12) AND B(10));
TERMS(23) <= (A(11) AND B(12)) XOR (A(12) AND B(11));
TERMS(24) <= (A(12) AND B(12));
```

122

```
RESULT_M(0)  <= TERMS(0) XOR TERMS(13) XOR TERMS(22) XOR TERMS(23);
RESULT_M(1)  <= TERMS(1) XOR TERMS(13) XOR TERMS(14) XOR TERMS(22) XOR TERMS(24);
RESULT_M(2)  <= TERMS(2) XOR TERMS(14) XOR TERMS(15) XOR TERMS(23);
RESULT_M(3)  <= TERMS(3) XOR TERMS(13) XOR TERMS(15) XOR TERMS(16) XOR TERMS(22) XOR TERMS(23) XOR TERMS(24);
RESULT_M(4)  <= TERMS(4) XOR TERMS(13) XOR TERMS(14) XOR TERMS(16) XOR TERMS(17) XOR TERMS(22) XOR TERMS(24);
RESULT_M(5)  <= TERMS(5) XOR TERMS(14) XOR TERMS(15) XOR TERMS(17) XOR TERMS(18) XOR TERMS(23);
RESULT_M(6)  <= TERMS(6) XOR TERMS(15) XOR TERMS(16) XOR TERMS(18) XOR TERMS(19) XOR TERMS(24);
RESULT_M(7)  <= TERMS(7) XOR TERMS(16) XOR TERMS(17) XOR TERMS(19) XOR TERMS(20);
RESULT_M(8)  <= TERMS(8) XOR TERMS(17) XOR TERMS(18) XOR TERMS(20) XOR TERMS(21);
RESULT_M(9)  <= TERMS(9) XOR TERMS(18) XOR TERMS(19) XOR TERMS(21) XOR TERMS(22);
RESULT_M(10) <= TERMS(10) XOR TERMS(19) XOR TERMS(20) XOR TERMS(22) XOR TERMS(23);
RESULT_M(11) <= TERMS(11) XOR TERMS(20) XOR TERMS(21) XOR TERMS(23) XOR TERMS(24);
RESULT_M(12) <= TERMS(12) XOR TERMS(21) XOR TERMS(22) XOR TERMS(24);
```

$x^0 = x^9 + I_0$

$x^1 = x^{10} + x^9 + I_1$

$x^2 = x^{10} + x^{11} + I_2$

$x^3 = x^{12} + x^{11} + x^9 + I_3$

$x^4 = x^{12} + x^{10} + x^9 + x^0$

$x^5 = x^{10} + x^{11} + x$

$x^6 = x^{12} + x^{11} + x^2$

$x^7 = x^{12} + x^3$

$x^8 = x^4$

$x^9 = x^5$

$x^{10} = x^6$

$x^{11} = x^7$

$x^{12} = x^8$

FIG. 20

$$x^0 = x^9 + x^{12} + I_0$$
$$x^1 = x^{10} + I_1$$
$$x^2 = x^{11} + I_2$$
$$x^3 = x^{12} + I_3$$
$$x^4 = x^9 + x^{12} + x^0$$
$$x^5 = x^9 + x^{10} + x^{12} + X$$
$$x^6 = x^{10} + x^{11} + x^2$$
$$x^7 = x^9 + x^{11} + x^3$$
$$x^8 = x^{10} + x^{12} + x^4$$
$$x^9 = x^9 + x^{11} + x^{12} + x^5$$
$$x^{10} = x^9 + x^{10} + x^6$$
$$x^{11} = x^{10} + x^{11} + x^7$$
$$x^{12} = x^{11} + x^{12} + x^8$$

FIG. 21

$$x^0 = x^9 + x^{11} + I_0$$
$$x^1 = x^9 + x^{10} + x^{11} + x^{12} + I_1$$
$$x^2 = x^{10} + x^{11} + x^{12} + I_2$$
$$x^3 = x^{11} + x^{12} + I_3$$
$$x^4 = x^9 + x^{11} + x^{12} + x^0$$
$$x^5 = x^{10} + x^{12} + x$$
$$x^6 = x^{11} + x^2$$
$$x^7 = x^9 + x^{11} + x^{12} + x^3$$
$$x^8 = x^9 + x^{10} + x^{11} + x^{12} + x^4$$
$$x^9 = x^{10} + x^{11} + x^{12} + x^5$$
$$x^{10} = x^{11} + x^{12} + x^6$$
$$x^{11} = x^9 + x^{11} + x^{12} + x^7$$
$$x^{12} = x^{10} + x^{12} + x^8$$

FIG. 22

FIG. 23A

FIG. 23B

FROM FIG. 23A

$$G(X) = G1(X) \cdot G3(X) \cdot G5(X)$$

$$X^0 = X^{35} + X^{37} + X^{38} + I_0 \qquad X^{20} = X^{35} + X^{37} + X^{16}$$

$$X^1 = X^{36} + X^{38} + I_1 \qquad X^{21} = X^{35} + X^{36} + X^{37} + X^{17}$$

$$X^2 = X^{35} + X^{38} + I_2 \qquad X^{22} = X^{36} + X^{37} + X^{38} + X^{18}$$

$$X^3 = X^{35} + X^{36} + X^{37} + X^{38} + I_3 \qquad X^{23} = X^{35} + X^{19}$$

$$X^4 = X^{36} + X^{37} + X^{38} + X^0 \qquad X^{24} = X^{35} + X^{36} + X^{37} + X^{38} + X^{20}$$

$$X^5 = X^{35} + X \qquad X^{25} = X^{36} + X^{37} + X^{38} + X^{21}$$

$$X^6 = X^{35} + X^{36} + X^{37} + X^{38} + X^2 \qquad X^{26} = X^{35} + X^{22}$$

$$X^7 = X^{35} + X^{36} + X^3 \qquad X^{27} = X^{36} + X^{23}$$

$$X^8 = X^{35} + X^{36} + X^{38} + X^4 \qquad X^{28} = X^{35} + X^{38} + X^{24}$$

$$X^9 = X^{36} + X^{37} + X^5 \qquad X^{29} = X^{35} + X^{36} + X^{37} + X^{38} + X^{25}$$

$$X^{10} = X^{35} + X^6 \qquad X^{30} = X^{35} + X^{36} + X^{26}$$

$$X^{11} = X^{35} + X^{36} + X^{37} + X^{38} + X^7 \qquad X^{31} = X^{35} + X^{36} + X^{38} + X^{27}$$

$$X^{12} = X^{35} + X^{36} + X^8 \qquad X^{32} = X^{36} + X^{37} + X^{28}$$

$$X^{13} = X^{35} + X^{36} + X^{38} + X^9 \qquad X^{33} = X^{35} + X^{29}$$

$$X^{14} = X^{36} + X^{37} + X^{10} \qquad X^{34} = X^{36} + X^{30}$$

$$X^{15} = X^{35} + X^{11} \qquad X^{35} = X^{35} + X^{38} + X^{31}$$

$$X^{16} = X^{36} + X^{12} \qquad X^{36} = X^{35} + X^{36} + X^{37} + X^{38} + X^{32}$$

$$X^{17} = X^{35} + X^{38} + X^{13} \qquad X^{37} = X^{35} + X^{36} + X^{33}$$

$$X^{18} = X^{36} + X^{14} \qquad X^{38} = X^{36} + X^{37} + X^{34}$$

$$X^{19} = X^{37} + X^{15}$$

*FIG. 24*

170

$t_1 = a_0 = a_{12}$     $a_5 = a_4$     $a_{10} = a_9$
    $a_1 = a_{12} + a_0$     $a_6 = a_5$     $a_{11} = a_{10}$
    $a_2 = a_1$     $a_7 = a_6$     $a_{12} = a_{11}$
    $a_3 = a_{12} + a_2$     $a_8 = a_7$
    $a_4 = a_{12} + a_3$     $a_9 = a_8$

$t_2 = a_0 = a_{11}$     $a_5 = a_{12} + a_3$     $a_{10} = a_8$
    $a_1 = a_{11} + a_{12}$     $a_6 = a_4$     $a_{11} = a_9$
    $a_2 = a_{12} + a_0$     $a_7 = a_5$     $a_{12} = a_{10}$
    $a_3 = a_{11} + a_1$     $a_8 = a_6$
    $a_4 = a_{11} + a_{12} + a_2$     $a_9 = a_7$

$t_3 = a_0 = a_{10}$     $a_5 = a_{11} + a_{12} + a_2$     $a_{10} = a_7$
    $a_1 = a_{10} + a_{11}$     $a_6 = a_{12} + a_3$     $a_{11} = a_8$
    $a_2 = a_{11} + a_{12}$     $a_7 = a_4$     $a_{12} = a_9$
    $a_3 = a_{10} + a_{12} + a_0$     $a_8 = a_5$
    $a_4 = a_{10} + a_{11} + a_1$     $a_9 = a_6$

$t_4 = a_0 = a_9$     $a_5 = a_{10} + a_{11} + a_1$     $a_{10} = a_6$
    $a_1 = a_9 + a_{10}$     $a_6 = a_{11} + a_{12} + a_2$     $a_{11} = a_7$
    $a_2 = a_{10} + a_{11}$     $a_7 = a_{12} + a_{13}$     $a_{12} = a_8$
    $a_3 = a_9 + a_{11} + a_{12}$     $a_8 = a_4$
    $a_4 = a_9 + a_{10} + a_{12} + a_0$     $a_9 = a_5$

NOTE: $a_9$, $a_{10}$, $a_{11}$, $a_{12}$ ARE DELAYED

GEN 1 COUNTS 0, 4, 8, 12 ...     START 1 0 0 0 0 0 0 0 0 0 0 0 0
GEN 2 COUNTS 1, 5, 9, 13 ...     START 0 0 0 0 0 0 0 0 0 0 0 0 1
GEN 3 COUNTS 2, 6, 10, 14 ...     START 0 0 0 0 0 0 0 0 0 0 0 1 0
GEN 4 COUNTS 3, 7, 11, 15 ...     START 0 0 0 0 0 0 0 0 0 0 1 0 0

    GO BACKWARDS, SAME WAY
    COUNT 1 START     8191 − 4320 = 3871 START

FIG. 25

180

```
architecture BEHAVIORAL of POWER_GEN is

signal LFSR_REVERSE: std_logic_vector(12 downto 0);
signal ALPHA_RET1: std_logic_vector(12 downto 0);
signal ALPHA_RET2: std_logic_vector(12 downto 0);

begin

ALPHA <= LFSR_REVERSE after 1 ns;

-- LFSR counting up from 8153 to 8191
process (RESET_F, CK_78)
begin
  if RESET_F = '0' then
       LFSR_REVERSE <= "0000000000001";
  elsif (CK_78' event and CK_78='1') then
    if START_COUNT='1' then
       LFSR_REVERSE <= "0000000000001"; --8153 for 39 checkbits
    elsif STOP_COUNT='1' then
       LFSR_REVERSE <= (others => '0');
    else
       LFSR_REVERSE(12) <= LFSR_REVERSE(0);
       LFSR_REVERSE(11) <= LFSR_REVERSE(12);
       LFSR_REVERSE(10) <= LFSR_REVERSE(11);
       LFSR_REVERSE(9) <= LFSR_REVERSE(10);
       LFSR_REVERSE(8) <= LFSR_REVERSE(9);
       LFSR_REVERSE(7) <= LFSR_REVERSE(8);
       LFSR_REVERSE(6) <= LFSR_REVERSE(7);
       LFSR_REVERSE(5) <= LFSR_REVERSE(6);
       LFSR_REVERSE(4) <= LFSR_REVERSE(5);
       LFSR_REVERSE(3) <= LFSR_REVERSE(4) xor LFSR_REVERSE(0);
       LFSR_REVERSE(2) <= LFSR_REVERSE(3) xor LFSR_REVERSE(0);
       LFSR_REVERSE(1) <= LFSR_REVERSE(2);
       LFSR_REVERSE(0) <= LFSR_REVERSE(1) xor LFSR_REVERSE(0);
    end if;
  end if;
end process;

-- Retime stages to sync up with squarer and cuber
process (RESET_F, CK_78)
begin
  if RESET_F='0' then

       ALPHA_RET1 <= (others => '0');
       ALPHA_RET2 <= (others => '0');
  elsif CK_78' EVENT AND ck_78='1' then
       ALPHA_RET1 <= ALPHA;
       ALPHA_RET2 <= ALPHA_RET1;
  end if;
end process;

-- Selecting appropriate bits for cuber and squarer.

ALPHA_CUBER <= ALPHA_RET1;
ALPHA_MULT <= ALPHA_RET2;
end;
```

*FIG. 26*